# EUROPÄISCHE PATENTSCHRIFT

(11) **EP 2 392 199 B1**
(45) Veröffentlichungstag und Bekanntmachung des Hinweises auf die Patenterteilung: **25.04.2018**
(21) Anmeldenummer: 10702812.8
(22) Anmeldetag: 22.01.2010
(51) Int. Cl.: H05K 3/00

(54) **VERFAHREN ZUR HERSTELLUNG EINER MEHRLAGIGEN LEITERPLATTE, HAFTVERHINDERUNGSMATERIAL SOWIE MEHRLAGIGE LEITERPLATTE UND VERWENDUNG EINES DERARTIGEN VERFAHRENS**
METHOD FOR PRODUCING A MULTILAYER PRINTED CIRCUIT BOARD, ADHESION PREVENTION MATERIAL AND MULTILAYER PRINTED CIRCUIT BOARD AND USE OF SUCH A METHOD
PROCÉDÉ DE FABRICATION DE CARTE À CIRCUITS IMPRIMÉS MULTICOUCHE, MATÉRIAU ANTI-ADHÉSION, CARTE À CIRCUITS IMPRIMÉS MULTICOUCHE, ET UTILISATION D'UN TEL PROCÉDÉ

(30) Priorität: 27.01.2009 AT 4709 U
(43) Veröffentlichungstag der Anmeldung: 07.12.2011
(73) Patentinhaber: AT & S Austria Technologie & Systemtechnik Aktiengesellschaft, 8700 Leoben-Hinterberg (AT)
(72) Erfinder: WEICHSLBERGER, Günther, A-8043 Graz (AT); STAHR, Johannes, A-8605 St. Lorenzen/Mürztal (AT); LEITGEB, Markus, A-8793 Trofaiach (AT); ZLUC, Andreas, A-8700 Leoben (AT); WEIDINGER, Gerald, 8700 Leoben (AT)
(74) Vertreter: Dilg, Haeusler, Schindelmann Patentanwaltsgesellschaft mbH
(86) Internationale Anmeldenummer: PCT/AT2010/000024
(87) Internationale Veröffentlichungsnummer: WO 2010/085830

(56) Entgegenhaltungen:
- EP-A1- 1 616 909
- EP-A1- 1 674 230
- EP-A1- 1 698 655
- WO-A1-2008/098269
- WO-A1-2008/098271
- JP-A- H0 263 584
- JP-A- H01 261 432
- US-A1- 2006 272 768

## Beschreibung

Die vorliegende Erfindung bezieht sich auf ein Verfahren zur Herstellung einer mehrlagigen Leiterplatte aus einer Mehrzahl von miteinander zu verbindenden, insbesondere zu verpressenden leitenden bzw. leitfähigen und nicht-leitenden bzw. isolierenden Schichten bzw. Lagen. Die vorliegende Erfindung bezieht sich darüber hinaus auf ein Haftverhinderungsmaterial zur Verwendung in einem derartigen Verfahren, und auf eine Verwendung eines derartigen Verfahrens zur Herstellung einer mehrlagigen Leiterplatte.

Wenn auch die nachfolgende Beschreibung auf die Herstellung einer mehrlagigen Leiterplatte Bezug nimmt, so ist anzumerken, daß das erfindungsgemäße Verfahren in unterschiedlichsten Anwendungsbereichen zum Einsatz gelangen kann, wobei darauf abgezielt wird, aus einer im wesentlichen flächigen Materialschicht einen Teilbereich nach einer Verbindung mit wenigstens einer weiteren, im wesentlichen flächigen Materialschicht zu entfernen. Allgemein ist die vorliegende Erfindung im Zusammenhang mit mehrlagigen Strukturen einsetzbar, bei welchen nach einer Herstellung einer mehrlagigen Struktur ein Teilbereich abgezogen bzw. eine der Schichten bzw. Lagen wenigstens teilweise entfernt werden soll. In diesem Zusammenhang sind beispielsweise aufwendige Verfahren und Konstruktionen bekannt, bei welchen insbesondere durch eine Vorkonfektionierung wenigstens einer für eine Verbindung der miteinander zu verbindenden Materialschichten eingesetzten Verbindungsschicht und entsprechend hohem Arbeitsaufwand und entsprechend hohem Aufwand für eine nachfolgende ordnungsgemäße Ausrichtung bzw. Registrierung der miteinander zu verbindenden Materialschichten darauf abgezielt wird, nach einer Verbindung derartiger Materialschichten Teilbereiche freizulegen bzw. zu entfernen. Die im wesentlichen flächigen Materialschichten können hiebei neben mehrlagigen Leiterplatten aus beispielsweise papier- oder kartonartigen, miteinander zu verbindenden Schichten bzw. Elementen, im wesentlichen platten- bzw. blattförmigen Elementen, wie beispielsweise Folien, Blechen oder metallischen Platten oder ähnlichen gebildet werden. Im Zusammenhang mit einer Verbindung von im wesentlichen flächigen bzw. plattenartigen Materialien ist es insbesondere für eine gegebenenfalls erforderliche nachträgliche Entfernung wenigstens eines Teilbereichs beispielsweise bekannt, Folien, welche Hafteigenschaften aufweisen, entsprechend vorzukonfektionieren, so daß Teilbereiche der Folien, welche während des Verbindungsvorgangs ein Anhaften der miteinander zu verbindenden Materialschichten bereitstellen sollen, mit Ausnehmungen versehen werden.

Alternativ können neben im wesentlichen vollflächigen Klebefolien entsprechend dem nachträglich zu entfernenden Teilbereich vorkonfektionierte Trennfolien eingesetzt werden, wie dies beispielsweise der DE-C 40 03 344 entnehmbar ist, wobei in dieser Literaturstelle auch die Verwendung einer flüssigen Trennschicht vorgeschlagen wird. Es ist unmittelbar einsichtig, daß eine derartige Vorkonfektionierung derartiger Verbindungsfolien bzw. Klebefolien und/oder Trennfolien mit entsprechend hohem Aufwand verbunden ist und darüber hinaus entsprechend hohe Anforderungen an eine Registrierung bzw. Ausrichtung der miteinander zu verbindenden Materialschichten unter Zwischenschaltung derartiger, insbesondere vorkonfektionierter Folien stellt.

Aus der EP-A 1 674 230 ist ein mehrlagiges Blatt bzw. Element bekannt geworden, welches unter Verwendung des oben genannten Verfahrens eingesetzt wird, wobei eine Freigabeschicht ähnlich dem ein Anhaften verhindernden Material wirkt, wobei auf eine gute Wärmebeständigkeit und Ablösbarkeit abgezielt wird. In ähnlicher Weise ist aus der EP-A 1 698 655 eine Freigabeschicht bzw. ein ein Anhaften verhinderndes Material bekannt geworden.

Aus der WO 2008/098271 oder der WO 2008/098269 ist darüber hinaus beispielsweise ein Verfahren der obigen Art zu entnehmen, wobei als ein Anhaften verhinderndes Material eine wachsartige Paste eingesetzt wird, wobei eine derartige wachsartige Paste nach einem Aufbringen bei einer nachfolgenden Verpressung einer von mehreren Lagen gebildeten mehrschichtigen Leiterplatte unter erhöhtem Druck und/oder erhöhter Temperatur zu einem Auslaufen des ein Anhaften verhindernden Materials führen kann. Darüber hinaus ist es bei Einsatz eines wachsartigen Materials nachteilig, daß ein derartiges ein Anhaften verhinderndes Material nach einem Entfernen des zu entfernenden Teilbereichs kaum oder nur unter stark erhöhtem Aufwand wiederum entfernbar ist, um beispielsweise eine nachfolgende Strukturierung und/oder Kontaktierung der mehrlagigen Leiterplatte in dem Bereich, von welchem der zu entfernende Teilbereich entfernt wurde, zu ermöglichen.

Im Zusammenhang mit einer Herstellung von mehrlagigen elektronischen Bauteilen, insbesondere mehrlagigen Leiterplatten führt die in den letzten Jahren an Komplexität zunehmende Konstruktion derartiger elektronischer Bauteile allgemein zu einem Erhöhen der Anzahl von Verbindungs- bzw. Anbindungspunkten von aktiven Bauteilen zu Bestandteilen einer Leiterplatte, wobei mit einer zunehmenden Reduktion der Größe gleichzeitig eine Reduktion des Abstands zwischen derartigen Anbindungspunkten vorzusehen ist. Im Zusammenhang mit der Herstellung von Leiterplatten wurde hiebei beispielsweise eine Entflechtung von derartigen Verbindungs- bzw. Anbindungspunkten von Bauteilen über Mikrovias über mehrere Leiterplattenlagen hinweg in sogenannten High Density Interconnects (HDI) vorgeschlagen.

Neben einer zunehmenden Erhöhung der Komplexität des Designs bzw. der Konstruktion von Leiterplatten, beispielsweise im Zusammenhang mit einer Ausbildung von Kavitäten bzw. Hohlräumen und einer damit einhergehenden Miniaturisierung sind zusätzliche Anforderungen im Hinblick auf falz- bzw. biegefähige Verbindungen in einer Leiterplatte entstanden, welche zur Entwicklung einer Hybridtechnik und zum Einsatz sogenannter starr-flexibler Leiterplatten führten. Derartige starr-flexible Leiterplatten, welche aus starren Bereichen bzw. Teilbereichen der Leiterplatte sowie derartige starre Bereiche verbindenden, flexiblen Bereichen bestehen, erhöhen die Zuverlässigkeit, bieten weitere bzw. zusätzliche Möglichkeiten einer Freiheit des Designs bzw. der Konstruktion und ermöglichen weitere Miniaturisierungen.

Zur Herstellung derartiger starr-flexibler Leiterplatten sind zwischen starren und flexiblen Bereichen einer Leiterplatte diese entsprechenden Verbindungsschichten aus einem dielektrischen Material vorzusehen, wobei eine Anordnung von entsprechenden blattförmigen Schichten bzw. Folien, welche beispielsweise durch eine Wärmebehandlung zu einer Verbindung von miteinander zu verbindenden, starren und flexiblen Bereichen einer Leiterplatte führen, üblicherweise vergleichsweise dicke Schichten ergibt. Derartige dicke Schichten wirken nicht nur einer beabsichtigten Miniaturisierung bei der Herstellung von mehrlagigen Leiterplatten entgegen, sondern führen auch zu einem Verlust an Registriergenauigkeit für nachfolgende Laser-Bohrlochgeometrien zur Ausbildung der Mikrovias und entsprechend eng beabstandeter Verbindungs- bzw. Anbindungsstellen. Derartige dicke, bekannte Schichten aus nicht-leitendem Material bzw. Dielektrikumschichten führen darüber hinaus zu zusätzlichen Verarbeitungs- bzw. Prozeßschritten und/oder zu einem aufwendigeren Design zur Herstellung der erforderlichen Verbindungen zwischen den starren und flexiblen Bereichen der Leiter platten, da insbesondere eine entsprechende Vorkonfektionierung bzw. Formatierung entsprechend der nachfolgenden Durchtrennung der starren Bereiche der Leiterplatte vorzusehen ist.

Die vorliegende Erfindung zielt darauf ab, unter Vermeidung der Probleme des oben genannten Standes der Technik ein Verfahren zur Herstellung einer mehrlagigen Leiterplatte zur Verfügung zu stellen, wobei nach einem Verbinden, insbesondere Verpressen von mehreren Schichten bzw. Lagen ein Teilbereich zuverlässig entfernt werden kann und insbesondere ein leicht und zuverlässig auftragbares, ein Anhaften verhinderndes Material zur Verfügung gestellt wird, welches darüber hinaus bevorzugt nach einem Entfernen des zu entfernenden Teilbereichs einfach und zuverlässig sowie vollständig wieder entfernt werden kann, so daß auch im Bereich des zu entfernenden Teilbereichs eine zuverlässige weitere Bearbeitung der mehrlagigen Leiterplatte vorgenommen werden kann. Darüber hinaus zielt die Erfindung darauf ab, ein derartiges ein Anhaften verhinderndes Material bzw. Haftverhinderungsmaterial zur Verwendung in einem derartigen Verfahren sowie eine Verwendung eines Verfahrens zur Herstellung einer mehrlagigen Leiterplatte unter Vermeidung der oben genannten Probleme gemäß dem Stand der Technik und unter Bereitstellung der obigen Ziele bzw. Merkmale zur Verfügung zu stellen.

Diese Aufgaben werden gelöst durch ein Verfahren gemäß Anspruch 1, durch ein Haftverhinderungsmaterial gemäß Anspruch 20 bzw. durch eine Verwendung gemäß Anspruch 21. Vorteilhafte Weiterbildungen der Erfindung sind in den abhängigen Ansprüchen beschrieben. Da das ein Anhaften verhindernde Material neben einem Bindemittel und einem Lösungsmittel als Trennmittel wenigstens eine Metallseife enthält, wird sichergestellt, daß das ein Anhaften verhindernde Material einfach und zuverlässig aufgebracht werden kann und eine optimale Trennwirkung auch nach insbesondere mehrmaliger Bearbeitungsvorgänge bei der Herstellung einer mehrlagigen Leiterplatte, insbesondere im Hinblick auf eine Verbindung einzelner Schichten bzw. Lagen insbesondere unter erhöhter Temperatur und/oder erhöhtem Druck zur Verfügung stellt. Darüber hinaus hat sich erwiesen, daß unter Verwendung wenigstens einer Metallseife als Trennmittel eine gegenüber bekannten Materialien, wie beispielsweise wachsartigen Pasten, verbesserte Strukturierbarkeit bei der Aufbringung des ein Anhaften verhindernden Materials erzielbar ist und eine derartige Struktur auch während des nachfolgenden Verbindungs- bzw. Verpreßvorgangs zuverlässig aufrecht erhalten wird. Derartige Metallseifen werden vorzugsweise in Form der fettsauren Salze von AI, Mg, Ca, Na oder Zn eingesetzt, wobei dies insbesondere leicht und zuverlässig bearbeitbare und verarbeitbare Materialien zur Verfügung stellt, welche ein Anhaften eines Teilbereichs zuverlässig verhindern und somit dessen einfache und nachträgliche Entfernbarkeit ermöglichen. Zur Erzielung der gewünschten Trennwirkung nach einem Herstellen der mehrlagigen Leiterplatte insbesondere unter Einsatz von wenigstens teilweise erhöhtem Druck und/oder erhöhter Temperatur wird erfindungsgemäß vorgeschlagen, daß das Trennmittel in einer Menge von weniger als 60 Gew.-%, insbesondere etwa 5 Gew.-% bis 45 Gew.-% des ein Anhaften verhindernden Materials eingesetzt wird.

Zur Bereitstellung zuverlässig be- bzw. verarbeitbarer Trennmittel zur Erzielung der gewünschten, ein Anhaften verhindernden Eigenschaften wird gemäß einer bevorzugten Ausführungsform vorgeschlagen, daß das Trennmittel auf Basis von gesättigten und ungesättigten Fettsäuren, wie beispielsweise Stearin-, Palmitin- und Ölsäuren eingesetzt wird.

Für eine zuverlässige Festlegung bzw. Anordnung des ein Anhaften verhindernden Materials während des Aufbringvorgangs und insbesondere um eine Anhaftung des Trennmittels des erfindungsgemäßen, ein Anhaften verhindernden Materials sicherzustellen und eine gewünschte Rheologie einzustellen, welche ein entsprechend zuverlässiges und einfaches Aufbringen des ein Anhaften verhindernden Materials ermöglicht, wird darüber hinaus bevorzugt vorgeschlagen, daß als Bindemittel ein Zellulosederivat, insbesondere Zelluloseether oder -ester, vorzugsweise Ethylzellulose eingesetzt wird.

Bei der Herstellung von mehrlagigen Leiterplatten ist davon auszugehen, daß insbesondere Schichten aus gehärtetem Harz und/oder Kupfer mit ungehärteter Harzschicht in einem Verbindungsvorgang, insbesondere einem Verpreßvorgang insbesondere bei erhöhter Temperatur und/oder erhöhtem Druck miteinander verbunden werden. Dabei verflüssigt sich das Harz der ungehärteten Harzschicht beispielsweise bei Temperaturen von etwa 70 °C und erreicht bei einem weiteren Anheben der Temperatur auf etwa 200 °C durch Polymerisation einen festen Zustand in Form eines Duroplasten, wobei dies zu einer Verbindung einzelner benachbarter Schichten bei der Herstellung einer mehrlagigen Leiterplatte führt.

Durch Einsatz eines Bindemittels in Form eines Zellulosederivats, insbesondere Ethylzellulose erfolgt während des Verbindungsvorgangs einzelner Schichten insbesondere eine Migration dieses Bindemittels in die anschließende Schicht einer sich während des Verbindungsvorgangs verflüssigenden Harzschicht, beispielsweise aus Epoxyharz oder Phenolharz der mehrlagigen Leiterplatte, so daß das ein Anhaften verhindernde Material während des Verbindungsvorgangs durch diese Migration an Bindemittel verarmt, wodurch die nachfolgende gewünschte Trennwirkung bei einem Entfernen des zu entfernenden Teilbereichs durch die Verarmung an Bindemittel an einer Grenzschicht, auf welcher das ein Anhaften verhindernde Material aufgebracht ist bzw. wird, weiter verbessert wird.

Zur Erzielung der gewünschten Eigenschaften im Hinblick insbesondere auf ein zuverlässiges Anhaften bzw. Festlegen während des Aufbringungsvorgangs des in weiterer Folge ein Anhaften verhindernden Materials als auch zur Erzielung der oben beschriebenen Verbesserung der Trennwirkung durch eine Migration während des Verbindungsvorgangs in eine benachbarte Schicht bzw. Lage der mehrlagigen Leiterplatte wird gemäß einer weiters bevorzugten Ausführungsform vorgeschlagen, daß die Menge an Bindemittel weniger als 35 Gew.-%, insbesondere zwischen 3 Gew.-% und 25 Gew.-% gewählt wird.

Für ein zuverlässiges Aufbringen des ein Anhaften verhindernden Materials enthält dieses darüber hinaus ein Lösungsmittel, wobei gemäß einer weiters bevorzugten Ausführungsform des erfindungsgemäßen Verfahrens das Lösungsmittel einen Siedepunkt von weniger als 220 °C, insbesondere etwa 180 °C bis 200 °C aufweist. Durch Einsatz eines derartigen Lösungsmittels mit einem vergleichsweise hohen Siedepunkt wird einerseits sichergestellt, daß während einer Aufbringung des ein Anhaften verhindernden Materials keine Probleme beispielsweise im Hinblick auf eine vorzeitige Trocknung desselben vor der Anordnung weiterer Schichten bzw. Lagen der herzustellenden Leiterplatte auftreten. Weiters wird durch einen derartigen Siedepunkt des Lösungsmittels sichergestellt, daß bei einer Erhöhung der Temperatur im Rahmen der Verbindung einzelner Schichten bzw. Lagen der Leiterplatte beispielsweise bis auf eine Temperatur von etwa 220 °C das Lösungsmittel aus dem ein Anhaften verhindernden Material im wesentlichen vollständig entfernt und verdampft wird.

Zur Bereitstellung der gewünschten Eigenschaften des ein Anhaften verhindernden Materials wird vorgeschlagen, daß als Lösungsmittel Ethylen- oder Polypropylenglycolether und -ester eingesetzt werden, wie dies einer weiters bevorzugten Ausführungsform des erfindungsgemäßen Verfahrens entspricht. Für eine entsprechend gute Verarbeitbarkeit des ein Anhaften verhindernden Materials wird darüber hinaus bevorzugt vorgeschlagen, daß die Menge an Lösungsmittel weniger als 85 Gew.-%, insbesondere 30 Gew.-% bis 80 Gew.-% des ein Anhaften verhindernden Materials beträgt.

Wie oben bereits mehrfach ausgeführt, ermöglicht das im Rahmen des erfindungsgemäßen Verfahrens eingesetzte ein Anhaften verhindernde Material insbesondere durch die Verwendung wenigstens einer Metallseife als Trennmittel ein besonders zuverlässiges Aufbringen als auch eine entsprechend gute Strukturierbarkeit, wobei in diesem Zusammenhang gemäß einer weiters bevorzugten Ausführungsform vorgeschlagen wird, daß das ein Anhaften verhindernde Material durch ein Druckverfahren, insbesondere durch Siebdruck, Schablonendruck, Offsetdruck, Flexodruck, Tampondruck, Tintenstrahldruck oder dgl. aufgebracht wird. Dadurch wird ein besonders einfaches und positionsgenaues Aufbringen des von einer Verbindung freizustellenden Bereichs bzw. des ein Anhaften verhindernden Teilbereichs für die nachträgliche Entfernung eines Teilbereichs zur Verfügung gestellt. Darüber hinaus sind derartige Druckverfahren nicht nur für sich gesehen bekannt, sondern werden auch teilweise weit verbreitet im Zusammenhang mit einer Herstellung einer Leiterplatte zur Strukturierung von einzelnen Schichten bzw. Lagen während unterschiedlicher Verarbeitungsvorgänge bzw. Bearbeitungsschritte eingesetzt, so daß Verfahrensabläufe bei der Herstellung einer mehrlagigen Leiterplatte unter zusätzlichem Einsatz des erfindungsgemäßen Verfahrens nicht einer grundlegenden Änderung der Verfahrensführung bei einer Herstellung einer mehrlagigen Leiterplatte bedürfen und lediglich mit ergänzenden und leicht integrierbaren Verfahrensschritten das Auslangen gefunden werden kann.

Für eine besonders einfache Verarbeitung des ein Anhaften verhindernden Materials im Zusammenhang mit dem erfindungsgemäßen Verfahren wird darüber hinaus bevorzugt vorgeschlagen, daß das ein Anhaften verhindernde Material nach einem Aufbringen einem Trocknungs- und/oder Härtungsverfahren unterworfen wird. Ein derartiges Trocknungs- und/oder Härtungsverfahren kann entsprechend den eingesetzten Materialien für das ein Anhaften verhindernde Material durchgeführt werden und insbesondere in Abstimmung mit den daran anschließenden Schichten bzw. Lagen der mehrlagigen Leiterplatte gewählt werden.

Zur Erzielung gewünschter geringer Schichtstärken bzw. -dicken des ein Anhaften verhindernden Materials unter Aufrechterhaltung der erfindungsgemäß vorgesehenen Freistellung des zu entfernenden Teilbereichs bzw. zur Verhinderung eines Anhaftens wird gemäß einer weiters bevorzugten Ausführungsform vorgeschlagen, daß das ein Anhaften verhindernde Material in einer Schichtstärke von weniger als 25 µm, insbesondere weniger als 15 µm aufgetragen wird.

Wie oben bereits mehrfach ausgeführt, muß sichergestellt werden, daß selbst bei mehrfachen Be- bzw. Verarbeitungsvorgängen im Zusammenhang mit der Herstellung einer mehrlagigen Leiterplatte unter erhöhter Temperatur und/oder erhöhtem Druck ein Anhaften des nachträglich zu entfernenden Teilbereichs verhindert wird. Ein für das erfindungsgemäß vorgesehene Trennmittel auf Basis wenigstens einer Metallseife für das ein Anhaften verhindernde Material wirkendes Trennprinzip, welches ein nachfolgendes Entfernen des zu entfernenden Teilbereichs ermöglicht, basiert im Prinzip auf der Unverträglichkeit aufgrund von Polaritätsunterschieden zwischen während des Verbindungsvorgangs aneinander angrenzenden Schichten bzw. Lagen während der Herstellung der mehrlagigen Leiterplatte. In diesem Zusammenhang wird gemäß einer weiters bevorzugten Ausführungsform vorgeschlagen, daß das ein Anhaften verhindernde Material einen Polaritätsunterschied zu den daran anschließenden, im wesentlichen flächigen Schichten bzw. Lagen aufweist. Durch Bereitstellen eines derartigen Polaritätsunterschieds zwischen dem ein Anhaften verhindernden Material und der sich während des Verbindungs- bzw. Verpreßvorgangs verflüssigenden Schichten einer mehrlagigen Leiterplatte, insbesondere einer verflüssigten Harzschicht aus Epoxy- und Phenolharz bildet sich eine Phasengrenze, so daß sich die aneinander angrenzenden Schichten nicht vermischen und insbesondere eine Verbindung zwischen der ein Anhaften verhindernden Schicht und einer angrenzenden Schicht nicht erfolgt. Diese Phasengrenze bleibt auch nach einem nachfolgenden Abkühlen nach Vornahme eines Verbindungs- bzw. Verpreßvorgangs aufrecht, so daß der zu entfernende Teilbereich entsprechend zuverlässig beispielsweise nach einer Entfernung von Seitenbereichen, wie dies nachfolgend im Detail erörtert werden wird, entfernt werden kann.

Zur Erzielung des gewünschten Trenneffekts durch ein Freistellen durch ein Aufbringen des ein Anhaften verhindernden Materials wird in diesem Zusammenhang gemäß einer weiters bevorzugten Ausführungsform vorgeschlagen, daß das Haftverhinderungsmaterial einen Erweichungs- bzw. Fließpunkt von wenigstens 100 °C, insbesondere wenigstens 120 °C aufweist. Durch einen derartig hohen Erweichungs- bzw. Schmelzpunkt der Schicht aus dem ein Anhaften verhindernden Material kommt bei der Herstellung einer mehrlagigen Leiterplatte während des Verbindungsvorgangs dazu, daß die Viskosität des im Verlauf des Verbindungsvorgangs verflüssigten Materials zu diesem Zeitpunkt bereits hoch genug ist, um zu verhindern, daß das verflüssigte Trennmittel des ein Anhaften verhindernden Materials über die Grenzen der gewünschten herzustellenden Struktur hinausgedrückt wird. Es wird somit sichergestellt, daß selbst bei einer weiteren Erhöhung der Temperatur während des Verbindungs- bzw. Verpreßvorgangs, wie dies oben erwähnt wurde, die durch das ein Anhaften verhindernde Material für die nachträgliche Entfernung des Teilbereichs erforderliche Freistellung zuverlässig aufrecht erhalten wird. Das ein Anhaften verhindernde Material verhindert somit während des Verbindungs- bzw. Verpreßvorgangs durch Ausbildung einer flüssigen Schicht bei vergleichsweise hohem Erweichungs- bzw. Schmelzpunkt im Bereich des nachträglich zu entfernenden Teilbereichs eine vollflächige Verbindung, beispielsweise Verklebung bzw. Verbindung der aneinander angrenzenden bzw. miteinander zu verbindenden Materialschichten, wie dies in Bereichen, welche an den nachträglich zu entfernenden Teilbereich angrenzen, gewünscht bzw. angestrebt wird.

Wie oben bereits erwähnt, läßt sich durch Einsatz wenigstens einer Metallseife als Trennmittel für das ein Anhaften verhindernde Material im Rahmen des erfindungsgemäßen Verfahrens darüber hinaus sicherstellen, daß nach einer Entfernung des zu entfernenden Teilbereichs in weiterer Folge gegebenenfalls vorhandene Restbestände des ein Anhaften verhindernden Materials zuverlässig entfernt werden können, wobei in diesem Zusammenhang gemäß einer weiters bevorzugten Ausführungsform des erfindungsgemäßen Verfahrens vorgeschlagen wird, daß nach einem Entfernen des zu entfernenden Teilbereichs das ein Anhaften verhindernde Material durch Aufbringen eines Stripmediums entfernt wird.

Zur Erzielung der gewünschten Entfernungseigenschaften des Stripmediums wird darüber hinaus vorgeschlagen, daß das Stripmedium von einem Gemisch aus einem Lösungsmittel mit hohem Siedepunkt und einer Säure gebildet wird, wie dies einer weiters bevorzugten Ausführungsform des erfindungsgemäßen Verfahrens entspricht. Durch Bereitstellung eines Stripmediums aus einem Gemisch aus einem Lösungsmittel mit hohem Siedepunkt und einer Säure läßt sich das ein Anhaften verhindernde Material nach Entfernung des entfernenden Teilbereichs zuverlässig entfernen, so daß auch im Bereich des zu entfernenden Teilbereichs weitere Be- bzw. Verarbeitungsvorgänge der mehrlagigen Leiterplatte, beispielsweise im Hinblick auf eine weitere Strukturierung und/oder Kontaktierung ermöglicht werden.

Für ein besonders zuverlässiges Aufbringen des Stripmediums und zur Erzielung einer gewünschten Reinigungs- bzw. Entfernungswirkung des ein Anhaften verhindernden Materials bzw. von Restbeständen desselben nach einer Entfernung des zu entfernenden Teilbereichs wird gemäß einer weiters bevorzugten Ausführungsform für das Stripmedium vorgeschlagen, daß das ein Anhaften verhindernde Material durch Besprühen mit insbesondere erwärmtem Lösungsmittel unter erhöhtem Druck oder in einem Tauchbecken unter Zuhilfenahme von Ultraschall oder mechanischen Rührwerken zur Verbesserung der Löslichkeit entfernt wird.

Zur Erzielung entsprechend zuverlässiger und guter Aufbringeigenschaften des Stripmediums wird gemäß einer weiters bevorzugten Ausführungsform vorgeschlagen, daß das Stripmedium wenigstens 80 Gew.-%, insbesondere wenigstens 90 Gew.-% des Lösungsmittels mit hohem Siedepunkt enthält.

Eine besonders zuverlässige Entfernungswirkung des ein Anhaften verhindernden Materials läßt sich bevorzugt dadurch erzielen, daß das Lösungsmittel gewählt wird aus der Gruppe, enthaltend Ethylenglycol, Diethylenglycol- und Polyglycolether, insbesondere Butylglycol, Hexylglycol, Butyldiglycol, Propylenglycolether und -ester, insbesondere Acetate, Alkohole, Ketone und Ester, sowie chlorierte Lösungsmittel.

Neben einem Lösungsmittel mit hohem Siedpunkt enthält, wie oben angeführt, das im Rahmen des erfindungsgemäßen Verfahrens eingesetzte Stripmedium auch eine Säure, wobei zur Erzielung der entsprechend gewünschten Reinigungswirkung gemäß einer bevorzugten Ausführungsform vorgeschlagen wird, daß die Säure im Stripmedium in einer Menge von weniger als 20 Gew.-%, insbesondere 0,5 Gew.-% bis 10 Gew.-% eingesetzt wird.

Zur Erzielung der gewünschten Entfernungswirkung und in Abhängigkeit von den für die Herstellung der mehrlagigen Leiterplatte eingesetzten Materialien wird gemäß einer weiters bevorzugten Ausführungsform für das Stripmedium vorgeschlagen, daß die Säure im Stripmedium von anorganischen Säuren, wie beispielsweise Salzsäure oder Schwefelsäure, oder organischen Säuren, wie insbesondere Oxalsäure, Essigsäure, Ameisensäure oder komplexbildende Säuren, wie beispielsweise Ethylendiamintetraessigsäure gebildet wird. Durch Einsatz derartiger Säuren wird die gewünschte Reinigungs- bzw. Entfernungswirkung von Restbeständen des ein Anhaften verhindernden Materials bewirkt, wobei gegebenenfalls bzw. gewünschtenfalls gleichzeitig durch Einsatz derartiger Säuren eine Ätz- oder Polierwirkung von insbesondere leitenden bzw. leitfähigen Schichten im Bereich des zu entfernenden, ein Anhaften verhindernden Materials erzielt werden kann.

In Abhängigkeit von dem eingesetzten Stripmedium als auch den eingesetzten Materialien zur Herstellung der mehrlagigen Leiterplatte wird gemäß einer weiters bevorzugten Ausführungsform vorgeschlagen, daß das Entfernen des ein Anhaften verhindernden Materials bei einer Temperatur von weniger als 150 °C, insbesondere zwischen 20 °C und 120 °C durchgeführt wird. Derart läßt sich entsprechend rasch und einfach das ein Anhaften verhindernde Material nach Entfernung des zu entfernenden Teilbereichs zuverlässig unter gleichzeitiger Schonung der insbesondere daran angrenzenden Schichten der mehrlagigen Leiterplatte vornehmen.

Im Zusammenhang mit der Herstellung der mehrlagigen Leiterplatte wird gemäß einer weiters bevorzugten Ausführungsform vorgeschlagen, daß die miteinander zu verbindenden Schichten bzw. Lagen der mehrlagigen Leiterplatte durch einen Laminierprozeß verbunden werden. Im Rahmen eines derartigen Laminierprozesses können hiebei neben den oben erwähnten Materialeigenschaften des ein Anhaften verhindernden Materials, beispielsweise im Hinblick auf den Erweichungs- bzw. Schmelzpunkt des ein Anhaften verhindernden Materials sowie den Siedepunkt des darin enthaltenen Lösungsmittels auch spezielle Erfordernisse insbesondere im Zusammenhang mit der Herstellung der mehrlagigen Leiterplatte und der hiezu eingesetzten Materialien berücksichtigt werden.

Für eine besonders zuverlässige und einfache Entfernung bzw. Lösung des nach der Verbindung der miteinander zu verbindenden flächigen Materialschichten zu entfernenden Teilbereichs wird darüber hinaus vorgeschlagen, daß Randbereiche des wenigstens einen zu entfernenden Teilbereichs durch ein Fräsen, Ritzen, Schneiden, insbesondere laserschneiden definiert und/oder entfernt werden, wie dies einer weiters bevorzugten Ausführungsform des erfindungsgemäßen Verfahrens entspricht. Ein derartiges Fräsen, Ritzen, Schneiden oder dgl. kann in Anpassung an die miteinander zu verbindenden flächigen Materialien entsprechend genau und zuverlässig durchgeführt werden, wobei selbst bei Verwendung von geringe Dicken bzw. Stärken aufweisenden Materialien, wie beispielsweise im Zusammenhang mit der Herstellung einer mehrlagigen Leiterplatte, eine entsprechend genaue und zuverlässige Durchführung des Trennvorgangs möglich ist. Darüber hinaus sind durch die ein Anhaften verhindernde Materialschicht die Anforderungen an die hierfür einzuhaltenden Toleranzen entsprechend geringer.

Durch das erfindungsgemäße Haftverhinderungsmaterial lassen sich, wie oben bereits ausführlich erwähnt, die günstigen Eigenschaften im Hinblick auf eine einfache Verarbeitbarkeit des erfindungsgemäßen Haftverhinderungsmaterials, eine zuverlässige Strukturierung als auch eine einfache und zuverlässige nachfolgende Entfernung von Restbeständen desselben erzielen.

Wie bereits mehrfach ausgeführt, wird darüber hinaus erfindungsgemäß vorgeschlagen, das erfindungsgemäße Verfahren und/oder das erfindungsgemäße Haftverhinderungsmaterial zur Herstellung einer mehrlagigen Leiterplatte einzusetzen.

Insbesondere im Zusammenhang mit einer derartigen erfindungsgemäßen Verwendung wird darüber hinaus bevorzugt vorgeschlagen, das erfindungsgemäße Verfahren oder die erfindungsgemäße mehrlagige Struktur zur Erzeugung von Hohlräumen, insbesondere dreidimensionalen Hohlräumen bzw. Kavitäten in einer Leiterplatte zu verwenden.

Die derart erzeugten Hohlräume, Kavitäten bzw. insbesondere Kanäle können weiters für den Transport von flüssigen oder gasförmigen Stoffen bzw. im Fall von Kanälen auch zur Einführung von Metallen unterschiedlicher geometrischer Form zur Wärmespreizung bzw. Wärmeabfuhr aus der Leiterplatte herangezogen werden, wie dies einer bevorzugten Verwendung entspricht.

Weiters ist es denkbar, daß derartige Kavitäten, insbesondere Kanäle zur Transmission von Licht- oder Schallwellen in der Leiterplatte herangezogen werden, wie dies einer weiters bevorzugten Verwendung entspricht. Auf diese Weise ist zum Beispiel in Kombination mit in Kavitäten eingesetzten LEDs eine seitliche Beleuchtung aus der Leiterplatte heraus möglich.

Weiters ist es möglich, diese Kavitäten, insbesondere Kanäle zur Leitung von Schall zu verwenden, wodurch vor allem für die Verwendung im Mikrofon- bzw. Lautsprecherbereich bei mobilen elektronischen Geräten, wie Handhelds, PDAs, Mobiltelefonen, usw. große Vorteile bei der Unterdrückung von Stör- und Nebengeräuschen ermöglicht werden, die ein Fachmann unter dem Begriff der Noise-Cancellation zusammenfaßt.

Weiters wird bevorzugt vorgeschlagen, diese Kavitäten und Hohlräume, insbesondere Kanäle durch galvanische oder chemisch-physikalische Abscheideverfahren oder durch Abscheideverfahren aus der Gasphase, beispielsweise Sputtertechniken, PVD, CVD, etc. mit metallischen Partikeln bzw. isolierenden oder inhibierenden Schichten zu versehen und derart leitende Schichten oder Versiegelungscoatings oder Schichten mit aktiver chemischer Oberfläche, beispielsweise zur Rezeption von flüssigen, festen oder gasförmigen Stoffen im Fall von Sensoren abzulagern und aufzubauen.

Weitere bevorzugte Verwendungsmöglichkeiten des erfindungsgemäßen Verfahrens liegen in einer Erzeugung wenigstens eines Kanals in einer Leiterplatte, einer Freistellung zur Erzeugung von Hohlräumen, insbesondere dreidimensionalen Hohlräumen bzw. Kavitäten in einer Leiterplatte, einer Herstellung von abgesetzten und/oder stufenförmig ausgebildeten Teilbereichen einer Leiterplatte, einer Freistellung wenigstens eines Elements, insbesondere Registrierelements im Inneren bzw. in Innenlagen einer mehrlagigen Leiterplatte und/oder einer Herstellung einer starr-flexiblen Leiterplatte.

Die Erfindung wird nachfolgend anhand von in der beiliegenden Zeichnung schematisch dargestellten Ausführungsbeispielen des erfindungsgemäßen Verfahrens zur Herstellung einer erfindungsgemäßen, mehrlagigen Leiterplatte unter Einsatz des erfindungsgemäßen, ein Anhaften verhindernden Materials als auch eines Stripmediums zum nachträglichen Entfernen des ein Anhaften verhindernden Materials näher erläutert.

In dieser zeigen:
Fig. 1 ein schematisches Flußdiagramm des erfindungsgemäßen Verfahrens zur Herstellung einer mehrlagigen Leiterplatte;
Fig. 2 ein schematisches Diagramm von Temperatur und Viskosität eines im Rahmen einer Herstellung einer mehrlagigen Leiterplatte beispielsweise eingesetzten Harzmaterials als auch eines erfindungsgemäßen, ein Anhaften verhindernden Materials;
Fig. 3 einen schematischen Schnitt durch eine erste Ausführungsform einer flächigen Materialschicht einer erfindungsgemäß herzustellenden mehrlagigen Leiterplatte in Form eines starren Bereichs einer starr-flexiblen Leiterplatte;
Fig. 4 in einer zu Fig. 3 ähnlichen Darstellung einen Schnitt durch den starren Bereich der starr-flexiblen Leiterplatte, wobei Fräskanten im Bereich einer nachfolgenden Durchtrennung des zu entfernenden Teilbereichs des starren Bereichs vorgesehen sind;
Fig. 5 in einer zu Fig. 3 und 4 ähnlichen Darstellung den Schnitt durch den starren Bereich der starr-flexiblen Leiterplatte, wobei im Bereich der nachfolgenden Durchtrennung sowie der Fräskanten zur Ausbildung einer Freistellung zur Verhinderung einer unmittelbaren Verbindung zwischen den von dem starren Bereich und dem flexiblen Bereich der Leiterplatte gebildeten im wesentlichen flächigen Materialschichten ein ein Anhaften verhinderndes Material gemäß der Erfindung vorgesehen bzw. aufgebracht ist;
Fig. 6 einen zu den vorangehenden Figuren wiederum ähnlichen Schnitt, wobei eine Schicht aus nicht-leitendem Material bzw. einem Dielektrikum und ein flexibler Bereich der starr-flexiblen Leiterplatte als zweite im wesentlichen flächige Materialschicht auf dem starren Bereich der ersten Materialschicht angeordnet bzw. festgelegt sind;
Fig. 7 in einem wiederum ähnlichen Schnitt die erfindungsgemäße, mehrlagige Struktur in Form der starr-flexiblen Leiterplatte nach einer Durchtrennung des starren Bereichs;
Fig. 8 schematisch einen Schnitt durch eine abgewandelte Ausführungsform einer im wesentlichen flächigen Materialschicht einer mehrlagigen Leiterplatte als eine gemäß dem erfindungsgemäßen Verfahren herzustellende, erfindungsgemäße, mehrlagige Struktur;
Fig. 9 einen schematischen Schnitt durch die in Fig. 8 dargestellte flächige Materialschicht, wobei eine Schicht aus einem ein Anhaften verhindernden Material bzw. ein ein Anhaften verhinderndes Material gemäß der Erfindung aufgebracht ist bzw. wird;
Fig. 10 einen schematischen Schnitt durch die in Fig. 8 und 9 dargestellte flächige Materialschicht, welche mit wenigstens einer weiteren flächigen Materialschicht zur Herstellung der erfindungsgemäßen mehrlagigen Leiterplatte verbunden ist bzw. wird;
Fig. 11 in einer zu Fig. 10 ähnlichen Darstellung einen schematischen Schnitt durch den nachträglich zu entfernenden Teilbereich der mehrlagigen Struktur, welcher durch ein Schneiden begrenzt bzw. definiert ist; und
Fig. 12 eine Darstellung ähnlich zu Fig. 11 ist, wobei der bei der Darstellung gemäß Fig. 11 geschnittene bzw. begrenzte Teilbereich entfernt wird.

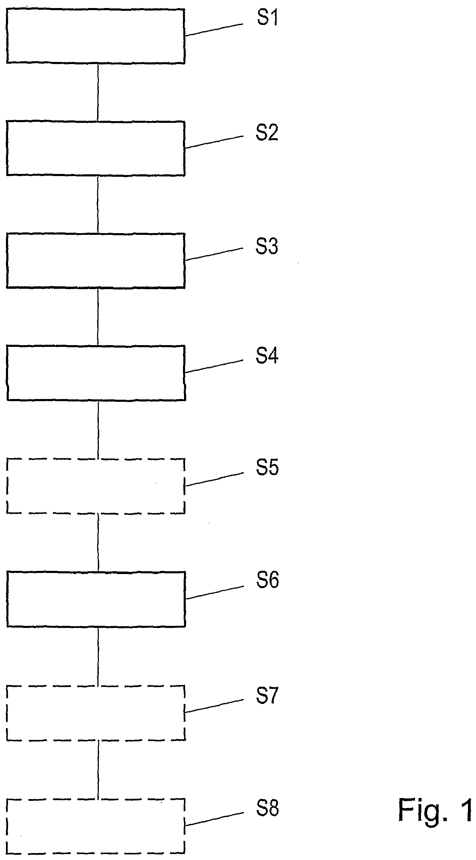

In dem schematischen Flußdiagramm von Fig. 1 ist in einem ersten Schritt S1 eine Bereitstellung einer ersten Materialschicht einer herzustellenden mehrlagigen Leiterplatte vorgesehen, worauf gegebenenfalls nach weiteren vorbereitenden, an sich bekannten Schritten einer Herstellung einer Leiterplatte, welche der Einfachheit halber hier nicht näher erläutert werden, in einem Schritt S2 die Aufbringung eines ein Anhaften verhindernden Materials, welches nachfolgend im Detail erörtert werden wird, vorgenommen wird. Die Aufbringung des ein Anhaften verhindernden Materials im Bereich eines im Verlauf nachfolgender Be- bzw. Verarbeitungsschritte zu entfernenden Teilbereichs, wie dies insbesondere anhand der nachfolgenden Figuren noch im Detail erörtert werden wird, ermöglicht nach weiteren Be- bzw. Verarbeitungsschritten, insbesondere Verbindungs- bzw. Verpreßvorgängen der in den nachfolgenden Figuren dargestellten mehrlagigen Leiterplatte die nachfolgende Entfernung eines Teilbereichs derselben.

Nach dem Aufbringen des ein Anhaften verhindernden Materials gemäß Schritt S2 erfolgt in einem Schritt S3 eine Anordnung bzw. Bereitstellung weiterer Schichten bzw. Lagen der herzustellenden mehrlagigen Leiterplatte aus leitendem bzw. leitfähigem und nicht leitendem bzw. isolierendem Material.

Nachfolgend wird, wie ebenfalls an sich bekannt, in Schritt S4 eine Verbindung der einzelnen in den Schritten S1 und S3 bereitgestellten Schichten bzw. Lagen der herzustellenden mehrlagigen Leiterplatte insbesondere durch ein Verpressen durch Anwenden einer erhöhten Temperatur und/oder eines erhöhten Drucks zur Verfügung gestellt, wie dies im Rahmen der Herstellung einer mehrlagigen Leiterplatte bekannt ist.

Nach dem Verbindungs-, insbesondere Verpreßvorgang gemäß Schritt S4 ist gemäß dem Flußdiagramm von Fig. 1 ein optionaler Schritt S5 vorgesehen, gemäß welchem für den Fall, daß der nachträglich zu entfernende Teilbereich nicht beispielsweise bereits in Schritt S3 entsprechend strukturiert vorgesehen bzw. aufgebracht wird, eine Strukturierung des zu entfernenden Teilbereichs beispielsweise durch ein Herstellen bzw. Definieren von Seitenrändern bzw. -kanten beispielsweise durch ein Fräsen oder Ritzen vorgenommen wird, wie dies ebenfalls nachträglich im Detail erörtert werden wird.

Nach dem gegebenenfalls vorgesehenen Schritt S5 erfolgt gemäß dem Schritt S6 des Flußdiagramms von Fig. 1 eine Entfernung des zu entfernenden Teilbereichs, wobei diese Entfernung des zu entfernenden Teilbereichs entsprechend einfach und zuverlässig durch Verwendung des ein Anhaften verhindernden Materials vorgenommen werden kann.

Nach einem Entfernen des zu entfernenden Teilbereichs entsprechend Schritt S6 erfolgt gemäß Schritt S7 gegebenenfalls ein Entfernen von verbleibenden Restbeständen des ein Anhaften verhindernden Materials durch Einsatz eines Stripmediums, wobei durch eine Verwendung eines ein Anhaften verhindernden Materials auf Basis wenigstens einer Metallseife, wie dies nachfolgend anhand von Ausführungsbeispielen im Detail erörtert werden wird, eine entsprechend zuverlässige und einfache Entfernung ermöglicht wird, wobei betreffend ein einzusetzendes Stripmedium ebenfalls auf die nachfolgenden Ausführungsbeispiele verwiesen wird.

Nach einer gegebenenfalls erfolgenden Entfernung von Restbeständen des ein Anhaften verhindernden Materials gemäß Schritt S7 erfolgt in wiederum bekannter Weise gegebenenfalls eine weitere Aufnahme bzw. Anordnung zusätzlicher Schichten bzw. Lagen der mehrlagigen Leiterplatte und eine Strukturierung derselben, wobei aufgrund der Bekanntheit der nachfolgenden Be- bzw. Verarbeitungsschritte eine detaillierte Erörterung derartiger weiterer Schritte hier nicht vorgenommen wird.

Im Zusammenhang mit der Herstellung einer mehrlagigen Leiterplatte durch Verbinden, insbesondere Verpressen einer Mehrzahl von leitenden bzw. leitfähigen und nicht-leitenden bzw. isolierenden Schichten bzw. Lagen ist es bekannt, daß für die Herstellung derartiger mehrlagiger Leiterplatten üblicherweise eingesetzte, glasfaserverstärkte Harzmaterialien mit teilweise entsprechend großen Unterschieden hinsichtlich Fließeigenschaften bzw. Schmelzviskosität verwendet werden.

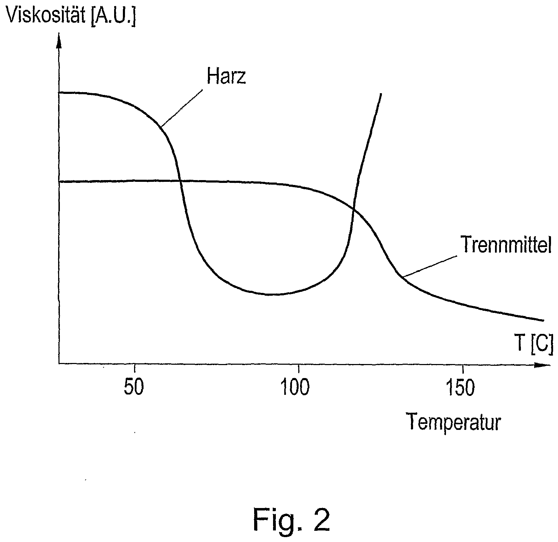

Im Rahmen einer Verbindung bzw. eines Verpressens derartiger Schichten bzw. Lagen einer mehrlagigen Leiterplatte wird beispielsweise das Minimum der Schmelzviskosität eines Prepregs eines derartigen glasfaserverstärkten Harzes im allgemeinen durch den Grad einer Vorvernetzung bestimmt und hängt darüber hinaus beispielsweise von der Aufheizrate in der zur Herstellung der mehrlagigen Leiterplatte verwendeten Presse ab. Ein Prepreg bzw. glasfaserverstärktes Harzmaterial auf Epoxyharzbasis weist beispielsweise ein Minimum der Schmelzviskosität und damit eine Verflüssigung im Bereich von 70 °C und 100 °C bei typischen Aufheizraten zwischen 2 °C und 5 °C auf, wie dies schematisch in Fig. 2 angedeutet ist.

Nach Erreichen der minimalen Viskosität und Erreichen eines entsprechenden Gelpunkts steigt die Viskosität durch die fortschreitende Vernetzung des Harzes beinahe sprunghaft an und führt üblicherweise zu einer schnellen Verfestigung eines derartigen, bei der Herstellung einer mehrlagigen Leiterplatte eingesetzten Harzmaterials, wie dies durch den steilen Anstieg in der Viskosität bei steigender Temperatur gemäß Fig. 2 ersichtlich ist. Eine derartige Verfestigung unter Ausbildung einer stark steigenden Viskosität kann hiebei innerhalb kürzester Zeit von beispielsweise 1 Minute bis 3 Minuten einsetzen.

Unter Berücksichtung dieses an sich bekannten Verhaltens der Viskosität von üblicherweise in der Herstellung von mehrlagigen Leiterplatten eingesetzten Materialien wird für das ein Anhaften verhindernde Material ein Trennmittel auf Basis wenigstens einer Metallseife eingesetzt, welches erst nach Erreichen der minimalen Viskosität von üblicherweise bei der Herstellung von mehrlagigen Leiterplatten eingesetzten Materialien schmilzt bzw. eine sich verringernde Viskosität aufweist, wie dies in dem schematischen Diagramm von Fig. 2 durch die sich verringernde Viskosität des Trennmittels bzw. des ein Anhaften verhindernden Materials erst nach Einsetzen der stark ansteigenden Viskosität unter Berücksichtung der Verfestigung von üblicherweise in der Herstellung einer mehrlagigen Leiterplatte verwendetem Material angedeutet ist.

Falls das eingesetzte Trennmittel bereits zu einem Zeitpunkt schmelzen und somit eine abnehmende Viskosität aufweisen sollte, zu welcher das Harzmaterial eine vergleichsweise geringe Viskosität aufweist, so wäre üblicherweise aufgrund der während der Verbindung der Lagen bzw. Schichten einer mehrlagigen Leiterplatte auftretenden erhöhten Temperaturen und Drücken davon auszugehen, daß die gewünschte strukturierte Aufbringung des ein Anhaften verhindernden Materials bzw. Trennmittels, wie dies nachfolgend noch im Detail erörtert werden wird, nicht zuverlässig aufrecht erhalten werden kann.

Darüber hinaus ist bekannt, daß bei Vorliegen von unterschiedlichen Polaritäten zwischen aneinander angrenzenden Schichten bzw. Lagen bzw. Materialien ein Vermischen derartig aneinander angrenzender Schichten bzw. Materialien weitestgehend verhindert wird, so daß bevorzugt das ein Anhaften verhindernde Material einen Polaritätsunterschied zu daran anschließenden Schichten bzw. Lagen der herzustellenden mehrlagigen Leiterplatte aufweist. Durch einen derartigen Polaritätsunterschied wird sichergestellt, daß selbst bei Einsetzen der Verringerung der Viskosität des eingesetzten Trennmittels bzw. des ein Anhaften verhindernden Materials ein Vermischen mit dem gegebenenfalls ebenfalls noch eine geringe Viskosität aufweisenden Harzmaterial verhindert wird, so daß die gewünschte Trennwirkung des ein Anhaften verhindernden Materials zuverlässig aufrecht erhalten werden kann. Durch Vorsehen eines derartig bevorzugten Polaritätsunterschieds wird darüber hinaus sichergestellt, daß auch während gegebenenfalls mehrfachen Verbindungs- bzw. Verpreßvorgängen das Trennmittel bzw. das ein Anhaften verhindernde Material seine Trennwirkung gegenüber benachbarten Schichten bzw. Lagen der mehrlagigen Leiterplatte nicht verliert, so daß die gewünschte Trennwirkung aufrecht erhalten werden kann.

Wie aus Fig. 2 ersichtlich, ist zur Erzielung der aufeinander abgestimmten Viskositäten sowohl eines üblicherweise bei der Herstellung einer mehrlagigen Leiterplatte eingesetzten Materials als auch des vorzusehenden Trennmittels bzw. des ein Anhaften verhindernden Materials wesentlich, daß das Trennmittel einen Schmelzpunkt höher als 120 °C, bevorzugt 140 °C bis 160 °C besitzt, um sicherzustellen, daß bei einsetzendem Schmelzen bzw. einsetzender Verringerung der Viskosität des Trennmittels die Viskosität des angrenzenden Materials der mehrlagigen Leiterplatte bereits ausreichend hoch ist bzw. ansteigt, um ein Vermischen der aneinander angrenzenden Materialien im Bereich der Grenzfläche zu vermeiden.

Neben dem Einsatz wenigstens eines Trennmittels auf Basis wenigstens einer Metallseife, wie dies nachfolgend noch im Detail erörtert werden wird, enthält das ein Anhaften verhindernde Material darüber hinaus neben einem Lösungsmittel auch ein Bindemittel, welches insbesondere günstige Eigenschaften während des Aufbringvorgangs, beispielsweise durch ein Drucken des ein Anhaften verhinderndes Materials zur Erzielung der gewünschten Strukturierung bereitstellt.

Ein derartiges Bindemittel wird beispielsweise von einem Zellulosederivat, insbesondere Zelluloseether oder -ester, vorzugsweise Ethylzellulose gebildet, wobei durch Einsatz von Ethylzellulose günstige Eigenschaften im Hinblick auf den vorzunehmenden Druckvorgang und die zu erzielende Strukturierung zur Verfügung gestellt werden. Unter Berücksichtung der stark unterschiedlichen Löslichkeit einer derartigen Metallseife sowie von Ethylzellulose ergibt sich bei Einsatz von Ethylzellulose als Bindemittel darüber hinaus der Vorteil, daß die relativ polare Matrix der Ethylzellulose während des Verbindungs- bzw. Verpreßvorgangs der einzelnen Schichten der mehrlagigen Leiterplatte wenigstens teilweise in das angrenzende Harzmaterial migriert, so daß das ein Anhaften verhindernde Material an der Grenzfläche zu einer anschließenden Materialschicht an Ethylzellulose bzw. allgemein Bindemittel verarmt. Diese Verarmung an Bindemittel begünstigt bzw. erhöht die Trennwirkung des ein Anhaften verhindernden Materials weiter, so daß die Entfernung eines zu entfernenden Teilbereichs in weiterer Folge ebenfalls begünstigt bzw. verbessert wird.

Die als Trennmittel einzusetzenden Metallseifen begünstigen darüber hinaus neben der bereits vorteilhaften Trennwirkung nach einer Entfernung eines zu entfernenden Teilbereichs, wie dies auf Basis der nachfolgenden Figuren im Detail erörtert werden wird, auch eine einfache und zuverlässige Entfernung des ein Anhaften verhindernden Materials durch ein Stripmedium, welches nachfolgend ebenfalls anhand von Ausführungsbeispielen näher erläutert werden wird. Es läßt sich durch Einsatz eines derartigen Stripmediums sicherstellen, daß gegebenenfalls Restbestände des ein Anhaften verhindernden Materials zuverlässig entfernt werden und somit der Bereich der mehrlagigen Leiterplatte, von welcher ein Teilbereich entfernt wurde, im Rahmen nachfolgender Be- bzw. Verarbeitungsschritte einer weiteren Bearbeitung, beispielsweise Strukturierung und Verbindung mit zusätzlichen Schichten bzw. Lagen unterworfen werden kann. Darüber hinaus ermöglicht die zuverlässige Entfernung des ein Anhaften verhindernden Materials beispielsweise die Entfernung von Teilbereichen einer mehrlagigen Leiterplatte für Reparaturzwecke, wobei nach ergänzender Entfernung des ein Anhaften verhindernden Materials mittels des Stripmediums neuerlich entsprechende Ersatzkomponenten der mehrlagigen Leiterplatte eingesetzt werden können.

Die Entfernung der ein Anhaften verhindernden Schicht ermöglicht außerdem, daß in der derart hergestellten Kavität auch elektronische Komponenten sowie mechanische Teile aus Kunststoff oder Metall, wie etwa Halterungen, mechanische Fixierungen und dgl. durch Löten oder Kleben mit flüssigen und pastösen Klebstoffen, Klebefolien oder metallhältigen Pasten angebracht bzw. thermisch oder elektrisch oder thermisch und elektrisch leitend angebunden werden können.

Als Trennmittel für das ein Anhaften verhindernde Material sind grundsätzlich alle Metallseifen auf Basis von gesättigten und ungesättigten Fettsäuren, beispielsweise Stearin-, Palmitin- und Ölsäure verschiedener Metalle, insbesondere Ca, Mg, Al, Zn, Na, oder dgl. einsetzbar. Der Anteil der Metallseife kann zwischen 5 % und 45 % variieren.

Weiters sind für das ein Anhaften verhindernde Material alle Lösungsmittel mit einer guten Löslichkeit für das Bindemittel und einem ausreichend hohen Siedepunkt für den Druckprozeß einsetzbar, wobei beispielsweise Ethylen- und Propylenglycolether und -ester (Butylglycol, Hexylglycol, Butyldiglycol), Diethylenglycol- und Polyglycolether und -ester genannt werden können. Der Lösungsmittelanteil kann zwischen 30 % - 80 % variieren.

Als Bindemittel können neben Ethylzellulose auch andere Zelluloseether und -ester verwendet werden.

Der prozentuelle Anteil an Bindemittel kann zwischen 3 % - 25 % variieren. Die Viskosität kann zwischen 9 cPs - 80 cPs variieren.

Als ein Anhaften verhinderndes Material können hiebei beispielsweise folgende Zusammensetzungen eingesetzt werden (Anteile jeweils in Gew.-%):

**Beispiel 1:**

| | |
|---|---|
| Magnesiumstearat | 27 |
| Dipropylenglycolmethyletheracetat | 67 |
| Ethylzellulose | 6 |

**Beispiel 2:**

| | |
|---|---|
| Aluminiumstearat | 30 |
| Dipropylenglycolmethyletheracetat | 64 |
| Ethylzellulose | 6 |

**Beispiel 3:**

| | |
|---|---|
| Calciumstearat | 30 |
| Dipropylenglycolmethyletheracetat | 64 |
| Ethylzellulose | 6 |

Zur Bereitstellung eines Stripmediums zur Entfernung von gegebenenfalls Restbeständen des ein Anhaften verhindernden Materials wird ein Gemisch aus einem Lösungsmittel mit hohem Siedepunkt und einer Säure zur Verfügung gestellt, wobei die Säure insbesondere zur Lösung der Metallkomponente der jeweils verwendeten Metallseite dient. Das insbesondere organische Lösungsmittel dient insbesondere zur Lösung des Bindemittels und der verwendeten Fettsäure des ein Anhaften verhindernden Materials. Für eine vollständige und einfache Entfernung des ein Anhaften verhindernden Materials wird das Stripmedium durch Sprühdüsen bei Drücken > 0,5 bar und < 10 bar, vorzugsweise 1, 5 bis 2,5 bar auf die zu entfernende Schicht gelenkt, wobei durch mechanische Abrasion sowie durch Anlösen des zu entfernenden Materials dessen Entfernung erreicht wird. Das Stripmedium wird vorzugsweise vorab auf Temperaturen > 20 °C und < 120 °C erwärmt und im heißen Zustand auf die Fläche appliziert, wobei die Besprühung durch die Düsen vorzugsweise von unten stattfindet, um die Bildung von Lösemittelseen bzw. -ansammlungen auf der Leiterplatte und in weiterer Folge die Sedimentation von allfällig nicht ganz aufgelösten Schwebeteilchen zu verhindern.

Die Entfernung des ein anhaftenden verhindernden Materials kann außerdem in Tauchbecken vorgenommen werden, wobei zur Unterstützung des Lösevorgangs mechanische Rührwerke oder Ultraschallgeber eingesetzt werden können.

Als Säure für das Stripmedium können insbesondere folgende Säuren verwendet werden: Mineralsäuren bzw. anorganische Säuren, wie Salzsäure oder Schwefelsäure, sowie organische Säuren, wie Oxalsäure, Essigsäure, Ameisensäure oder Komplexbildner, wie beispielsweise Ethylendiamintetraessigsäure.

Als Lösungsmittel sind insbesondere Lösungsmittel mit einer guten Löslichkeit für das Bindemittel des ein Anhaften verhindernden Materials einsetzbar, wie beispielsweise Ethylenglycol, Diethylenglycol- und Polyglycolether, wie beispielsweise Butylglycol, Hexylglycol, Butyldiglycol, Propylenglycolether und -ester, insbesondere Acetate. Weiters auch leichtflüchtige Lösungsmittel, wie Alkohole, vorzugsweise Isopropanol, Ketone, vorzugsweise Aceton, MEK, und Ester, insbesondere Ethylacetat, sowie chlorierte Lösungsmittel, vorzugsweise Methylenchlorid, Chloroform, Tetrachlorkohlenstoff.

Der Anteil an Säure kann hiebei beispielsweise zwischen 0,5 % und 10 % variieren.

Für eine zuverlässige und einfache Entfernung des ein Anhaften verhindernden Materials wird das Stripmedium bei Temperaturen zwischen 20 °C und 120 °C eingesetzt.

Beispiele für das Stripmedium sind wie folgt (Anteile jeweils Gew.-%):

**Stripmedium 1:**

| | |
|---|---|
| Dipropylenglycolmethyletheracetat | 90 |
| Essigsäure (100 %) | 10 |

**Stripmedium 2:**

| | |
|---|---|
| Isopropanol | 98 |
| HCl (19 %) | 2 |

**Stripmedium 3:**

| | |
|---|---|
| Butyldiglycol | 97 |
| HCl (19 %) | 3 |

**Stripmedium 4:**

| | |
|---|---|
| Acton | 95 |
| Ameisensäure conc. | 5 |

**Stripmedium 5:**

| | |
|---|---|
| Dipropylenglycolmethyletheracetat | 95 |
| HCl (19 %) | 5 |

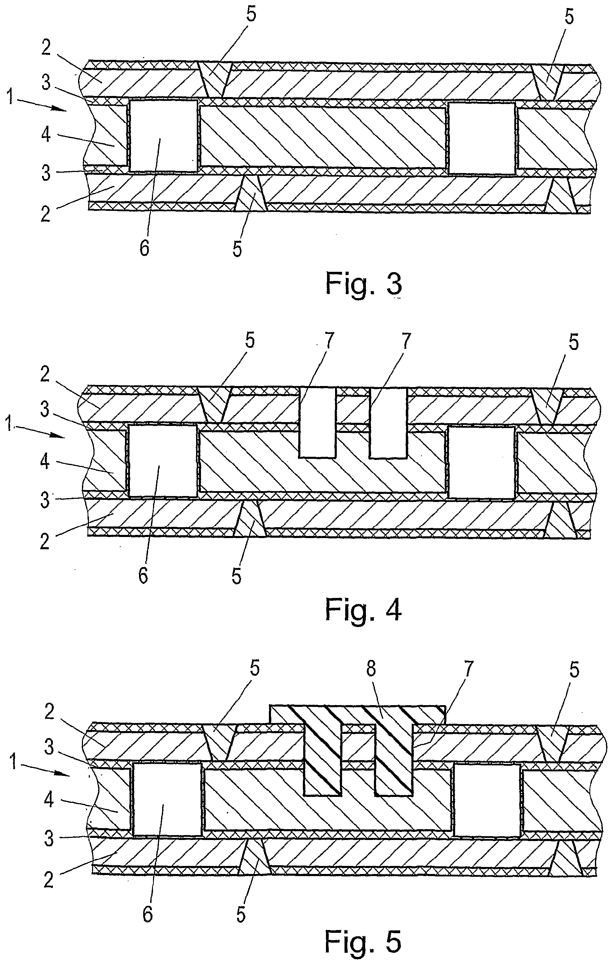

Das in Fig. 1 schematisch dargestellte Verfahren zur Herstellung einer mehrlagigen Leiterplatte unter Einsatz eines ein Anhaften verhindernden Materials für ein nachfolgendes Entfernen eines Teilbereichs einer derartigen mehrlagigen Leiterplatte wird nachfolgend anhand der in den Figuren 3 bis 7 bzw. 8 bis 12 dargestellten Ausführungsbeispiele der Herstellung unterschiedlicher mehrlagiger Leiterplatten näher erläutert.

In Fig. 3 ist eine schematische Darstellung eines starren, mehrlagigen Bereichs 1 als eine erste im wesentlichen flächige Materialschicht einer in weiterer Folge herzustellenden, starr-flexiblen Leiterplatte als einer mehrlagigen Struktur gezeigt. Hiebei sind einzelne Metall- bzw. Kupferschichten 2 beispielsweise durch isolierende bzw. Prepreg-Schichten 3 und einen Kern 4 getrennt. Verbindungen zwischen einzelnen Kupferschichten 2 sind über Mikrovias 5 sowie Durchtrittsöffnungen 6 angedeutet.

Zur Herstellung einer starr-flexiblen Leiterplatte werden im Bereich einer nachfolgenden Durchtrennung des starren, mehrlagigen Bereichs 1 der herzustellenden, starr-flexiblen Leiterplatte Fräskanten 7 ausgebildet, wie dies in Fig. 4 angedeutet ist.

Zur Erzielung einer Freistellung bzw. Verhinderung einer unmittelbaren Verbindung zwischen dem in weiterer Folge zu durchtrennenden, starren Bereich 1 der Leiterplatte und einer zur Verbindung mit einem flexiblen Bereich als zweiter im wesentlichen flächiger Materialschicht der Leiterplatte vorzusehenden und anzuordnenden Schicht aus nicht-leitendem Material oder einem Dielektrikum wird nachträglich an die Ausbildung der Fräskanten 7 in der in Fig. 3 bis 7 gezeigten Ausführungsform ein ein derartiges Anhaften verhinderndes Material bzw. Haftverhinderungsmaterial 8 im Bereich der nachfolgenden Durchtrennung und in den durch die Fräskanten 7 ausgebildeten Rillen bzw. Nuten beispielsweise entsprechend Schritt S2 von Fig. 1 angeordnet. Das ein Anhaften verhindernde Material 8, wie es oben im Detail erörtert wurde, wird in einfachen Verfahrensschritten, beispielsweise durch ein Druckverfahren, insbesondere durch Siebdruck oder Schablonendruck, im Bereich der nachfolgenden Durchtrennung sowie in die Fräskanten 7 aufgetragen bzw. eingebracht. Abhängig von dem eingesetzten Material 8 kann nachfolgend auf das Aufbringen des Materials 8 ein Trocknungs- und/oder Härtungsverfahren vorgesehen sein.

Zur Erzielung entsprechend geringer Schichtdicken bzw. Gesamtstärken der herzustellenden, starr-flexiblen Leiterplatte ist darüber hinaus vorgesehen, daß das ein Anhaften verhindernde Material 8 mit einer Schichtstärke von weniger als 25 µm, insbesondere weniger als 15 µm, im Bereich der nachfolgenden Durchtrennung und somit Entfernung eines Teilbereichs aufgebracht wird.

Während in der in Fig. 3 bis 7 dargestellten Ausführungsform eine Ausbildung der Fräskanten 7 vor dem Aufbringen des ein Anhaften verhinderndes Material 8 vorgesehen ist, kann alternativ das Material 8 im Bereich der nachfolgenden Durchtrennung des starren, insbesondere mehrlagigen Bereichs der Leiterplatte aufgebracht werden, wonach anschließend die Fräskanten 7 das aufgebrachte Material 8 durchdringen.

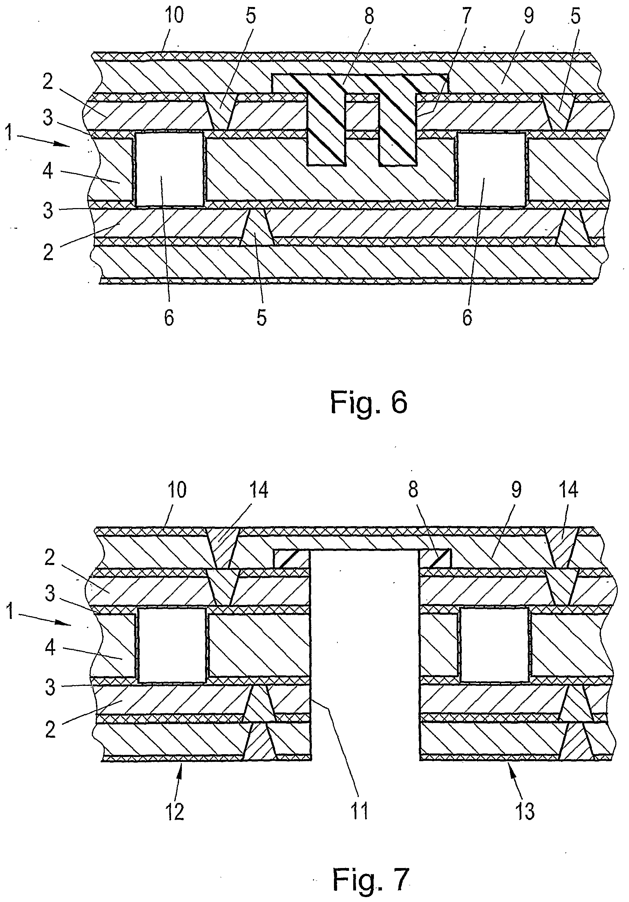

Wie in Fig. 6 gezeigt, erfolgt nach einem Aufbringen des ein Anhaften verhindernden Materials 8 im Bereich der nachfolgenden Durchtrennung sowie der Fräskanten 7 beispielweise entsprechend Schritt S3 von Fig. 1 eine Aufbringung bzw. Anordnung einer Verbindungsschicht 9 aus nicht-leitendem Material oder einem Dielektrikum, wobei diese Verbindungsschicht 9 beispielsweise von einer an sich bekannten Folie, beispielsweise einem Prepreg oder einer RCC-Folie, oder auch von einem flüssigen Dielektrikum gebildet sein kann. Anschließend an die Schicht 9 aus nicht-leitendem Material bzw. einem Dielektrikum ist ein flexibler Teilbereich 10 der herzustellenden, starr-flexiblen Leiterplatte angedeutet, wobei der flexible Bereich 10 der herzustellenden, starr-flexiblen Leiterplatte ebenso wie der starre Bereich 1 mehrlagig ausgebildet sein kann bzw. sind. Nach Anordnung der einzelnen Schichten bzw. Lagen erfolgt ein Verbinden, insbesondere Verpressen entsprechend Schritt S4 gemäß Fig. 1.

Durch die Anordnung des ein Anhaften verhindernden Materials 8 kann für die anzuordnende Schicht 9 aus nicht-leitendem Material oder einem Dielektrikum auf eine Vorkonfektionierung und/oder Formatierung insbesondere im Bereich der nachfolgenden Durchtrennung im Bereich der Fräskanten 7 verzichtet werden, so daß Vorbereitungsschritte für die anzuordnende Schicht 9 aus nicht-leitendem Material oder einem Dielektrikum vereinfacht bzw. verringert werden können. Betreffend den ein Anhaften verhindernden Mechanismus zwischen den einzelnen Schichten wird ergänzend auf die Ausführungen zu Fig. 2 verwiesen.

Durch das Vorsehen des freigestellten Bereichs im Bereich der Aufbringung des ein Anhaften verhindernden Materials 8 auf dem starren Bereich 1 der herzustellenden, starr-flexiblen Leiterplatte kann darüber hinaus mit geringeren Schichtstärken der Schicht 9 das Auslangen gefunden werden, deren Dicke beispielsweise mit weniger als 50 µm, insbesondere 40 µm oder weniger, gewählt wird. Durch Vorsehen derartiger geringer Schichtdicken der zwischen dem starren Bereich 1 und dem flexiblen Bereich 10 der herzustellenden, starr-flexiblen Leiterplatte anzuordnenden Schicht aus nicht-leitendem Material kann nicht nur eine Verringerung der Gesamtdicke der herzustellenden, mehrlagigen Leiterplatte unterstützt werden, sondern es kann auch die Positionier- sowie Registriergenauigkeit der miteinander zu verbindenden Bereiche und von nachfolgenden Durchtrittsöffnungen bzw. Mikrovias erhöht werden.

In Fig. 7 ist ein Schnitt durch die aus dem starren Bereich 1 und dem flexiblen Bereich 10 gebildete, starr-flexible Leiterplatte als mehrlagige Struktur dargestellt, wobei im Bereich der Fräskanten 7 eine Durchtrennung 11 zwischen den nunmehr voneinander getrennten, starren Teilbereichen 12 und 13 vorgenommen wurde. Diese Durchtrennung 11 stellt hiebei einen nach der Verbindung der flächigen Materialschichten nachträglich zu entfernenden Teilbereich gemäß Schritt S6 von Fig. 1 dar. Darüber hinaus ist angedeutet, daß eine Verbindung zwischen dem flexiblen Bereich 10 der Leiterplatte und den nunmehr voneinander getrennten, starren Teilbereichen 12 und 13 durch zusätzliche Mikrovias bzw. Durchtrittsöffnungen 14 erzielbar ist.

Wie aus der Darstellung gemäß Fig. 7 weiters ersichtlich, können ohne besondere Berücksichtigung bzw. ohne Einhaltung von sehr genauen Toleranzen betreffend die Schnittiefe der Durchtrennung bzw. des zu entfernenden Teilbereichs 11 durch Vorsehen des eine Verbindung freistehenden bzw. verhindernden Bereichs durch Aufbringen des ein Anhaften verhindernden Materials 8 auch die Herstellung der Durchtrennung und somit nachfolgende Verfahrensschritte vereinfacht werden.

Durch entsprechende Wahl des ein Anhaften verhindernden Materials 8 als auch der zwischen dem starren Bereich 1 bzw. den nachfolgend voneinander getrennten, starren Bereichen 12 und 13 und dem flexiblen Bereich 10 der Leiterplatte anzuordnenden Schicht 9 aus nicht-leitendem Material oder einem Dielektrikum bzw. Prepreg können weiters gesetzlich vorgeschriebene Beschränkungen bei der Verwendung bestimmter, gefährlicher Stoffe in Elektro- und Elektronikgeräten in einfacher Weise berücksichtigt werden.

Durch Vorsehen der Freistellung durch Aufbringen eines ein Anhaften verhindernden Materials 8 kann somit mit vereinfachten Verfahrensschritten insbesondere bei der Vorbereitung bzw. Herstellung der zwischen dem flexiblen Bereich 10 und dem starren Bereich 1 anzuordnenden Schicht 9 als auch nachfolgenden Verfahrensschritten bei der Durchtrennung das Auslangen gefunden werden.

Durch die Verwendung von geringen Schichtstärken für die Verbindung des flexiblen Bereichs 10 sowie des starren Bereichs 1 bzw. der voneinander getrennten, starren Bereiche 12 und 13 und der dadurch erzielbaren, geringen Schichtstärke sowie der daraus resultierenden Verbesserungen der Registriergenauigkeit, wird es darüber hinaus möglich, Leiterplatten mit flexiblen Lagen 10 für hochkomplexe Bauteile auch in großen Formaten, beispielsweise im Produktionsformat von HDI-Leiterplatten von mehr als 18 x 24 Zoll, zur Verfügung zu stellen.

Die in Fig. 3 bis 7 dargestellte Ausführungsform einer mehrlagigen, starren Leiterplatte bzw. eines starren Bereichs 1 der Leiterplatte stellt zu Illustrationszwecken lediglich ein vereinfachtes Beispiel einer derartigen mehrlagigen Leiterplatte als einer mehrlagigen Struktur dar, wobei eine größere Anzahl bzw. Vielzahl von insbesondere leitenden Schichten 2 als auch eine Kontaktierung über Mikrovias 5 bzw. Durchtrittsöffnungen 6 bzw. 14 entsprechend der gewünschten Komplexität des herzustellenden Bauteils Verwendung finden kann.

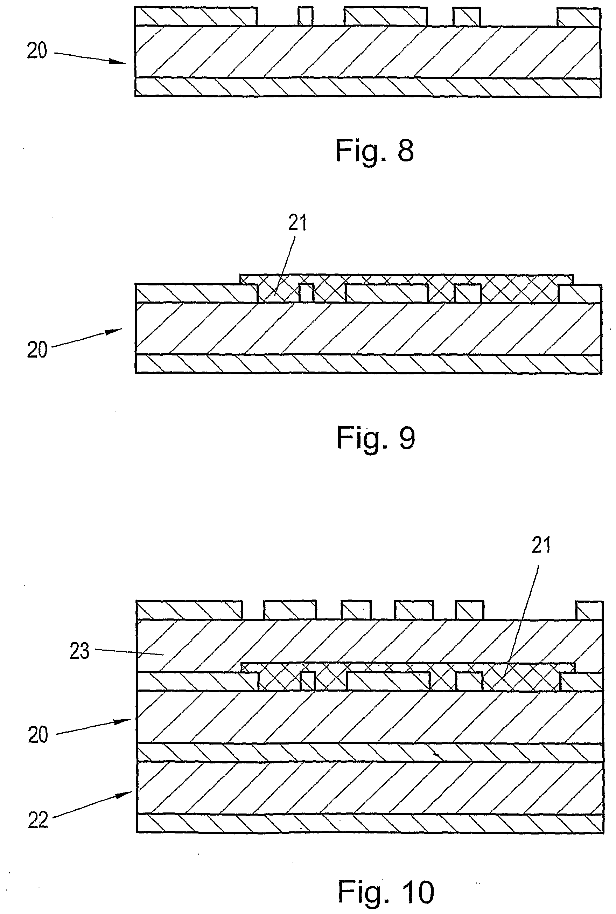

Bei dem in Fig. 8 bis 12 gezeigten Ausführungsbeispiel einer abgewandelten, mehrlagigen Struktur wiederum in Form einer herzustellenden, mehrlagigen Leiterplatte ist mit 20 allgemein ein strukturierter Kern einer derartigen Leiterplatte bezeichnet, wobei dieser Kern 20 aus mehreren Lagen bzw. Schichten besteht, wobei insbesondere die in Fig. 8 dargestellte obere Lage bzw. Schicht beispielsweise entsprechend Schritt S1 von Fig. 1 entsprechend strukturiert ist.

Der eine im wesentlichen flächige Materialschicht darstellende Kern 20 aus einer oder mehreren Lage(n) wird in weiterer Folge, wie dies in Fig. 9 gezeigt ist, für eine Verbindung mit weiteren Schichten bzw. Lagen als zusätzliche im wesentlichen flächige Materialschichten in einem Teilbereich mit einem ein Anhaften verhindernden Material bzw. Haftverhinderungsmaterial 21 beispielsweise gemäß Schritt S2 von Fig. 1 versehen, welches beispielsweise durch ein Siebdrucken aufgebracht wird.

Nachfolgend auf die in Fig. 9 gezeigte Aufbringung des ein Anhaften verhindernden Materials 21 auf die von dem Kern 20 gebildete, im wesentlichen flächige Materialschicht erfolgt eine Verbindung in an sich bekannter Weise gemäß Schritt S3 und S4 von Fig. 1 beispielsweise durch einen Laminiervorgang des flächigen Kerns 20 mit einer Vielzahl von wiederum im wesentlichen flächigen Materialschichten 22 und 23, wobei auch in Fig. 10 der mit dem ein Anhaften verhindernden Material versehene Teilbereich mit 21 bezeichnet ist. Die in Fig. 10 dargestellte flächige Materialschicht 23 kann wiederum insbesondere an ihrer Oberseite entsprechend strukturiert ausgebildet sein.

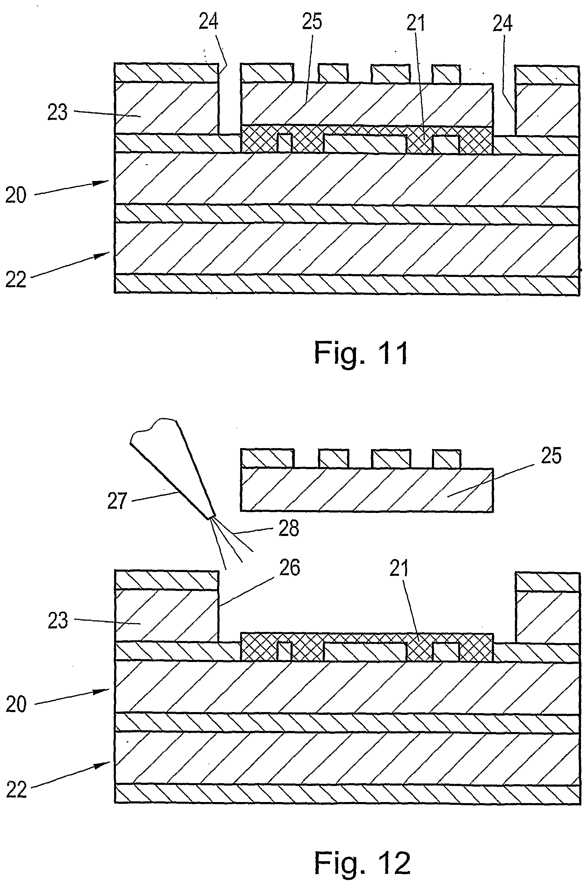

Nach dem in Fig. 10 dargestellten Verbindungsvorgang zwischen der Mehrzahl von im wesentlichen flächigen Materialschichten 20, 22 und 23 erfolgt, wie dies aus Fig. 11 ersichtlich ist und Schritt S5 von Fig. 1 entspricht, beispielsweise durch ein Schneiden, insbesondere ein Laserschneiden unter Ausbildung von Schnittlinien bzw. Vertiefungen 24 eine Begrenzung bzw. Definition eines Teilbereichs 25 der im wesentlichen flächigen Materialschicht 23. Durch das unterhalb des zu entfernenden Teilbereichs 25 vorgesehene ein Anhaften verhindernde Material 21 gelingt in einfacher Weise nach Ausbildung der Schnittlinie bzw. begrenzenden Vertiefungen 24 eine einfache und zuverlässige Entfernung des Teilbereichs 25, wie dies in Fig. 12 dargestellt bzw. angedeutet ist und Schritt S6 von Fig. 1 entspricht.

In der in Fig. 8 bis 12 dargestellten Ausführungsform sind zwischen bzw. neben den einzelnen im wesentlichen flächigen Materialschichten zusätzliche Schichten angedeutet, welche für sich gesehen im Zusammenhang mit der Herstellung einer mehrlagigen Leiterplatte bekannt sind und somit nicht im Detail erörtert werden, wie dies auch zu Schritt S8 von Fig. 1 angedeutet ist.

Auch bei der Ausführungsform gemäß Fig. 8 bis 12 ist klar ersichtlich, daß durch ein Vorsehen einer Freistellung im Zusammenhang mit einer Verbindung von im wesentlichen flächigen Materialien bzw. Materialschichten 20, 22 und 23 durch ein Aufbringen eines ein Anhaften verhindernden Materials 21 entsprechend den obigen Ausführungsbeispielen in weiterer Folge eine einfache und zuverlässige Entfernung von Teilbereichen 25 wenigstens einer miteinander zu verbindenden, im wesentlichen flächigen Schicht 23 ermöglicht wird.

Anstelle des in Fig. 11 dargestellten bzw. angeführten Schneidens, beispielsweise Laserschneidens, kann beispielsweise ein Fräsen, wie dies in der Ausführungsform gemäß Fig. 3 bis 8 gezeigt ist, oder ein Ritzen oder ähnliches Durchtrennen der wenigstens einen Materialschicht 23 vorgenommen werden.

In Fig. 12 ist darüber hinaus ein Sprühkopf bzw. eine Sprühdüse 27 angedeutet, mit welcher entsprechend den angedeuteten Strahlen 28 und entsprechend Schritt S7 von Fig. 1 nach einer Entfernung des zu entfernenden Teilbereichs 25 ein Stripmedium der oben genannten Art aufgebracht wird, um Restbestände des ein Anhaften verhindernden Materials 21 zu entfernen, um eine weitere Bearbeitung der mehrlagigen Leiterplatte auch im Bereich des zu entfernenden Teilbereichs 25 zu ermöglichen.

Bei der Ausführungsform gemäß Fig. 8 bis 12 ist ersichtlich, daß durch eine Entfernung des Teilbereichs 25 beispielsweise ein Hohlraum bzw. eine Kavität 26, insbesondere ein dreidimensionaler Hohlraum in Teilbereichen bzw. einzelnen Schichten bzw. Lagen einer mehrlagigen Leiterplatte hergestellt werden kann.

Ein derartiger Hohlraum 26 durch Entfernung des Teilbereichs bzw. Elements 25 kann darüber hinaus zur nachfolgenden Anordnung von getrennten Elementen in Innenbereichen bzw. inneren Lagen einer mehrlagigen Leiterplatte verwendet bzw. eingesetzt werden.

Darüber hinaus läßt sich durch eine Entfernung von Teilbereichen eine Leiterplatte mit abgesetzten und/oder stufenförmig ausgebildeten Teilbereichen für spezielle Anwendungszwecke zur Verfügung stellen.

Zusätzlich zu den in den obigen Ausführungsbeispielen genannten Druckverfahren, beispielsweise Siebdruckverfahren, zur Aufbringung des ein Anhaften verhindernden Materials 8 bzw. 21 können beispielsweise insbesondere in Abhängigkeit von der Beschaffenheit des Haftverhinderungsmaterials ein Offsetdruck, Flexodruck, Tampondruck, Tintenstrahldruck oder dgl. vorgesehen sein bzw. angewandt werden.

Durch die erfindungsgemäße Möglichkeit einer strukturierten Aufbringung des ein Anhaften verhindernden Materials auf Basis einer Metallseife 8 bzw. 21 lassen sich somit in einfacher Weise nachfolgende Verfahrensschritte insbesondere im Zusammenhang mit einer Entfernung von nachträglich entfernbaren Teilbereichen 11 bzw. 25 einer mehrlagigen Struktur vereinfachen.

Durch Einsatz einer beispielsweise durch eine einfache Drucktechnik aufbringbaren Schicht bzw. Lage aus einem ein Anhaften verhindernden Material 8 bzw. 21 kann auf im Stand der Technik vorgesehene Formatierungs- bzw. Konfektionierungstechniken beispielsweise für Trennfolien verzichtet werden.

Insbesondere im Zusammenhang mit der Herstellung bzw. Be- bzw. Verarbeitung von mehrlagigen Leiterplatten wird es durch das Freistellen bzw. Vorsehen eines ein Anhaften verhindernden Materials 8 bzw. 21 möglich, durch eine beispielsweise lokale Dickenreduktion einen Raum 26 für zusätzliche Bauelemente zur Verfügung zu steilen, wie dies oben erwähnt wurde. Durch eine derartige Bereitstellung eines Raums 26 insbesondere bzw. im wesentlichen im Inneren einer derartigen mehrlagigen Leiterplatte wird darüber hinaus ermöglicht, die gesamte Dicke einer derartigen mehrlagigen Leiterplatte durch ein Einbetten derartiger Bauteile zu verringern, so daß Anforderungen im Hinblick auf eine Miniaturisierung von Leiterplatten Rechnung getragen werden kann.

Durch eine lokale Dickenreduktion können die im Bereich des entfernten Teilbereichs 25 anzuordnenden zusätzlichen Bauelemente insbesondere nach einer Entfernung des gegebenenfalls verbleibenden, ein Anhaften verhindernden Materials 21, wie dies in Fig. 12 angedeutet ist, unmittelbar am Boden einer derartigen Ausnehmung bzw. eines derartigen Hohlraums 26 beispielsweise kontaktiert werden, wobei zur Verbesserung der Kontaktierung Restbestände des ein Anhaften verhindernden Materials 21 entfernt wurden, wie dies in Fig. 12 durch die Sprühdüse 27 angedeutet ist. Hiebei können in einfacher Weise beispielsweise bei der in Fig. 8 zur Verfügung gestellten Materialschicht 20 entsprechende Kontaktelemente bzw. leitfähige Strukturen im Bereich des nachträglich herzustellenden Hohlraums 26, wie dies in Fig. 12 dargestellt ist, vorgesehen bzw. zur Verfügung gestellt werden.

Wie oben bereits angeführt, können durch die nachträgliche Entfernung von Teilbereichen 25 unter Ausbildung von Hohlräumen 26 auch entsprechende dreidimensional offene oder gegebenenfalls geschlossene Hohlräume zur Verfügung gestellt werden, wobei in diesem Zusammenhang beispielweise ausgehend von dem in Fig. 12 dargestellten Zustand weitere Lagen einer mehrlagigen Leiterplatte angeordnet zur Verfügung gestellt werden können, wie dies Schritt S8 von Fig. 1 entspricht.

Darüber hinaus läßt sich durch entsprechende Wahl bzw. Anordnung des ein Anhaften verhindernden Materials 8 bis 21 eine Ausbildung von Hohlräumen 26 über mehrere Lagen bzw. Schichten einer derartigen mehrlagigen Leiterstruktur zur Verfügung stellen, wie dies beispielsweise bei der ersten Ausführungsform in Fig. 7 angedeutet ist.

Somit läßt sich im Zusammenhang mit der Herstellung von Leiterplatten durch Entfernen von Teilbereichen 25 beispielsweise auch eine entsprechend vereinfachte Freistellung von Registrierelementen zur Verfügung stellen.

Eine Ausbildung von stufenförmigen bzw. abgesetzten Teilbereichen ermöglicht beispielsweise die Herstellung von verschachtelten bzw. sich überschneidenden Bereichen einer mehrlagigen Leiterplatte.

Durch eine Entfernung von Teilbereichen durch Vorsehen des ein Anhaften verhindernden Materials 8 bzw. 21 ist es darüber hinaus möglich, beispielsweise eine Reparaturmöglichkeit bestehender bzw. bereits bestückter Leiterplatten mit eingebetteten Bauteilen zur Verfügung zu stellen, falls beispielsweise vorsorglich im Bereich von gegebenenfalls einer hohen Ausfalls- bzw. Beschädigungsrate ausgesetzten Bauelementen entsprechend ein ein Anhaften verhinderndes Material vorgesehen wird, so daß nach einem Schadhaftwerden eines derartigen Bauelements durch Entfernen eines Teilbereichs eine Leiterplatte repariert werden kann, und nicht vollständig ersetzt werden muß, so daß ein einfacher Austausch von Bauteilen möglich wird und eine mehrlagige Struktur, welche aus wenigstens zwei miteinander zu verbindenden, im wesentlichen flächigen Materialschichten besteht, einfach zur Verfügung gestellt werden kann.

## Patentansprüche

1. Verfahren zur Herstellung einer mehrlagigen Leiterplatte (1) aus einer Mehrzahl von miteinander zu verbindenden leitenden bzw. leitfähigen und nicht-leitenden bzw. isolierenden Schichten bzw. Lagen (2, 4, 9; 20, 22, 23), wobei nach einem Verbinden von wenigstens teilweise flächigen Schichten wenigstens ein Teilbereich (11, 25) derselben entfernt wird und zur Verhinderung eines Anhaftens des zu entfernenden Teilbereichs (11, 25) ein ein Anhaften verhinderndes Material (8, 21) entsprechend dem zu entfernenden Teilbereich (11, 25) auf einer Schicht (9) aufgebracht wird, welche an den zu entfernenden Teilbereich angrenzt, **dadurch gekennzeichnet, daß**
das ein Anhaften verhindernde Material (8, 21) von einem Gemisch aus einem Trennmittel auf Basis wenigstens einer Metallseife, einem Bindemittel und einem Lösungsmittel gebildet wird, und
das Trennmittel in einer Menge von weniger als 60 Gew.-% des ein Anhaften verhindernden Materials eingesetzt wird.

2. Verfahren nach Anspruch 1, **dadurch gekennzeichnet, daß** das Trennmittel auf Basis von gesättigten und ungesättigten Fettsäuren eingesetzt wird.

3. Verfahren nach Anspruch 1 oder 2, **dadurch gekennzeichnet, daß** als Bindemittel ein Zellulosederivat eingesetzt wird.

4. Verfahren nach einem der Ansprüche 1 bis 3, **dadurch gekennzeichnet, daß** die Menge an Bindemittel weniger als 35 Gew.-% gewählt wird.

5. Verfahren nach einem der Ansprüche 1 bis 4, **dadurch gekennzeichnet, daß** das Lösungsmittel einen Siedepunkt von weniger als 220°C aufweist.

6. Verfahren nach einem der Ansprüche 1 bis 5, **dadurch gekennzeichnet, daß** als Lösungsmittel Ethylen- oder Polypropylenglycolether und -ester eingesetzt werden.

7. Verfahren nach einem der Ansprüche 1 bis 6, **dadurch gekennzeichnet, daß** die Menge an Lösungsmittel weniger als 85 Gew.-% des ein Anhaften verhindernden Materials (8, 21) beträgt.

8. Verfahren nach einem der Ansprüche 1 bis 7, **dadurch gekennzeichnet, daß** das ein Anhaften verhindernde Material (8, 21) durch ein Druckverfahren aufgebracht wird.

9. Verfahren nach einem der Ansprüche 1 bis 8, **dadurch gekennzeichnet, daß** das ein Anhaften verhindernde Material (8, 21) nach einem Aufbringen einem Trocknungs- und/oder Härtungsverfahren unterworfen wird.

10. Verfahren nach einem der Ansprüche 1 bis 9, **dadurch gekennzeichnet, daß** das ein Anhaften verhindernde Material (8, 21) in einer Schichtstärke von weniger als 25 µm aufgetragen wird.

11. Verfahren nach einem der Ansprüche 1 bis 10, **dadurch gekennzeichnet, daß** das ein Anhaften verhindernde Material (8, 21) einen Polaritätsunterschied zu den daran anschließenden, im wesentlichen flächigen Schichten bzw. Lagen aufweist.

12. Verfahren nach einem der Ansprüche 1 bis 11, **dadurch gekennzeichnet, daß** das ein Anhaften verhindernde Material (8, 21) einen Erweichungs- bzw. Schmelzpunkt von wenigstens 120°C aufweist.

13. Verfahren nach einem der Ansprüche 1 bis 12, **dadurch gekennzeichnet, daß** nach einem Entfernen des zu entfernenden Teilbereichs (11, 25) das ein Anhaften verhindernde Material (8, 21) durch Aufbringen eines Stripmediums (28) entfernt wird.

14. Verfahren nach Anspruch 13, **dadurch gekennzeichnet, daß** das Lösungsmittel gewählt wird aus der Gruppe, enthaltend Ethylenglycol, Diethylenglycol- und Polyglycolether, Hexylglycol, Butyldiglycol, Propylenglycolether und -ester, sowie chlorierte Lösungsmittel.

15. Verfahren nach einem der Ansprüche 13 bis 14, **dadurch gekennzeichnet, daß** die Säure im Stripmedium (28) in einer Menge von weniger als 20 Gew.-% eingesetzt wird.

16. Verfahren nach einem der Ansprüche 13 bis 15, **dadurch gekennzeichnet, daß** die Säure im Stripmedium (28) von anorganischen Säuren oder organischen Säuren oder komplexbildenden Säuren gebildet wird.

17. Verfahren nach einem der Ansprüche 13 bis 16, **dadurch gekennzeichnet, daß** das Entfernen des ein Anhaften verhindernden Materials (8, 21) unter Einsatz des Stripmediums (28) bei einer Temperatur von weniger als 150°C durchgeführt wird.

18. Verfahren nach einem der Ansprüche 1 bis 17, **dadurch gekennzeichnet, daß** die miteinander zu verbindenden Schichten (2, 4, 9; 20, 22, 23) bzw. Lagen der mehrlagigen Leiterplatte (1) durch einen Laminierprozeß verbunden werden.

19. Verfahren nach einem der Ansprüche 1 bis 18, **dadurch gekennzeichnet, daß** Randbereiche (7, 24) des wenigstens einen zu entfernenden Teilbereichs (11, 25) durch ein Fräsen, Ritzen, Schneiden definiert und/oder entfernt werden.

20. Haftverhinderungsmaterial zur Verwendung in einem Verfahren nach einem der Ansprüche 1 bis 19, **dadurch gekennzeichnet, daß** das ein Anhaften verhindernde Material (8, 21) von einem Gemisch aus einem Trennmittel auf Basis wenigstens einer Metallseife, einem Bindemittel und einem Lösungsmittel gebildet wird und daß das Trennmittel in einer Menge von weniger als 60 Gew.-% des ein Anhaften verhindernden Materials eingesetzt wird.

21. Verwendung eines Verfahrens nach einem der Ansprüche 1 bis 19 oder eines Haftverhinderungsmaterials nach Anspruch 20 zur Herstellung einer mehrlagigen Leiterplatte (1).

22. Verwendung nach Anspruch 21, zur Erzeugung von Hohlräumen bzw. Kavitäten (25) in einer Leiterplatte.

23. Verwendung nach Anspruch 21, zur Erzeugung wenigstens eines Kanals in einer Leiterplatte.

24. Verwendung nach Anspruch 22 oder 23, zur Einbettung von elektronischen und/oder mechanischen Komponenten.

25. Verwendung nach Anspruch 22 oder 23, zur Leitung von Schall, Licht, Flüssigkeiten und/oder Gasen.

26. Verwendung nach Anspruch 22 oder 23, zur Aufnahme von elektronischen Komponenten und Bauelementen in den Hohlräumen bzw. Kavitäten (26).

27. Verwendung nach Anspruch 22 oder 23, wobei die Hohlräume, Kavitäten bzw. Kanäle (26) nachfolgend durch chemische, physikalische oder galvanische Abscheideverfahren mit leitenden, isolierenden, inhibierenden, resorbierenden, reflektierenden oder versiegelnden Schichten gefüllt, überzogen oder ausgekleidet werden.

28. Verwendung nach Anspruch 21, zur Freistellung wenigstens eines Elements im Inneren bzw. in Innenlagen einer mehrlagigen Leiterplatte (1).

29. Verwendung nach Anspruch 21, zur Herstellung von abgesetzten und/oder stufenförmig ausgebildeten Teilbereichen (26) einer Leiterplatte (1).

30. Verwendung nach Anspruch 21, zur Herstellung einer starr-flexiblen Leiterplatte (1).

## Claims

1. A method for manufacturing a multilayer printed circuit board (1) from a plurality of conductive respectively conductible and non-conductive respectively isolating layers respectively deposits (2, 4, 9; 20, 22, 23) to be combined, wherein
after combining at least partially plane layers at least one portion (11, 25) of them is removed and for prevention of an adhering of the portion (11, 25) to be removed an adhering preventing material (8, 21) is applied on a layer (9) corresponding to the portion (11, 25) to be removed, which layer (9) abuts at the portion to be removed,
**characterised in that**
the adhering preventing material (8, 21) is formed from a mixture of a release agent on the basis of at least a metal soap, a binding agent, and a solvent, and
the release agent is employed in a quantity of less than 60% mass fraction of the adhering preventing material.

2. The method of claim 1, **characterised in that** the release agent is employed on the basis of saturated and unsaturated fatty acids.

3. The method of claim 1 or 2, **characterised in that** a cellulose derivative is employed as binding agent.

4. The method of any one of claims 1 to 3, **characterised in that** the quantity of binding agent is selected of less than 35% mass fraction.

5. The method of any one of claims 1 to 4, **characterised in that** the release agent comprises a boiling point of less than 220 degrees Celsius.

6. The method of any one of claims 1 to 5, **characterised in that** ethylene- or polyethylene glycol ether and -ester are employed as release agent.

7. The method of any one of claims 1 to 6, **characterised in that** the quantity of release agent amounts less than 85% mass fraction of the adhering preventing material (8, 21).

8. The method of any one of claims 1 to 7, **characterised in that** adhering preventing material (8, 21) is deposited by means of a printing method.

9. The method of any one of claims 1 to 8, **characterised in that** after desposition adhering preventing material (8, 21) is subjected to a desiccation and/or curing method.

10. The method of any one of claims 1 to 9, **characterised in that** adhering preventing material (8, 21) is deposited with a layer thickness of less than 25 µm.

11. The method of any one of claims 1 to 10, **characterised in that** the adhering preventing material (8, 21) comprises a difference in polarity with respect to the substantially plane Layers respectively deposits, which are connected up the adhering preventing material.

12. The method of any one of claims 1 to 11, **characterised in that** the adhering preventing material (8, 21) comprises a softening point respectively melting point of at least 120 degrees Celsius.

13. The method of any one of claims 1 to 12, **characterised in that** after a removal of the portion (11, 25) to be removed adhering preventing material (8, 21) is removed by means of depositing a strip medium.

14. The method of claim 13, **characterised in that** the release agent is selected from a group containing ethylene glycol, diethyleneglycol- and polyglycol ether, hexylglycol, butyldiglycol, propyleneglycol ether and -ester, and chlorinated release agent.

15. The method of any one of claims 13 to 14, **characterised in that** the acid in the strip medium (28) is employed in a quantity of less than 20% mass fraction.

16. The method of any one of claims 13 to 15, **characterised in that** the acid in the strip medium (28) is formed from inorganic acids or organic acids or precipitating acids.

17. The method of any one of claims 13 to 16, **characterised in that** the removing of the adhering preventing material (8, 21) is carried out with use of the strip medium (28) at a temperature of less than 150 degrees Celsius.

18. The method of any one of claims 1 to 17, **characterised in that** the Layers (2, 4, 9; 20, 22, 23) to be combined of the multi-layered printed circuit board (1) are combined by a laminating process.

19. The method of any one of claim 1 to 18, **characterised in that** edge areas (7, 24) of the at least one portion to be removed are defined and/or removed by means of a milling, scratching, and cutting.

20. A adhering prevention material for a use in a method of any one of claims 1 to 19, **characterised in that**
the adhering preventing material (8, 21) is formed by a mixture of an release agent on the basis of at least a metal soap, a binding agent, and a solvent and that
the release agent is employed in a quantity of less than 60% mass fraction of the adhering preventing material.

21. Use of a method of any one of claims 1 to 19 or an adhering prevention material of claim 20 for manufacturing a multilayer printed circuit board (1).

22. Use of claim 21 for producing hollows respectively cavities (25) in a printed circuit board.

23. Use of claim 21 for producing at least one channel in a printed circuit board.

24. Use of claim 22 or 23 for embedding of electronic and/or mechanic components.

25. Use of claim 22 or 23 for guidance of sound, light, fluids, and/or gases.

26. Use of claim 22 or 23 for receiving electronic components and elements in the hollows respectively cavities (26).

27. Use of claim 22 or 23, wherein the hollows, cavities respectively channels (26) are consecutively filled, covered, or lined by means of chemical, physical or galvanic separation methods with conductive, isolating, inhibiting, resorbing, reflecting, or sealing layers.

28. Use of claim 21 for release of at least one element in the inside respectively internal layers of a multi-layered printed circuit board (1).

29. Use of claim 21 for manufacture of separate and/or stepped formed portions (26) of a printed circuit board (1).

30. Use of claim 21 for manufacture a stiff-flexible printed circuit board (1).

## Revendications

1. Procédé de fabrication d'une carte à circuits imprimés (1) multicouche composée d'une pluralité de couches ou d'épaisseurs (2, 4, 9 ; 20, 22, 23) conductrices ou électriquement conductrices et non conductrices ou isolantes à relier entre elles, dans lequel, après l'établissement d'une liaison entre des couches au moins partiellement planes, au moins une zone délimitée (11, 25) de celles-ci est enlevée et, pour empêcher une adhésion de la zone délimitée (11, 25) à enlever, un matériau anti-adhésion (8, 21) correspondant à la zone délimitée (11, 25) à enlever est appliqué sur une couche (9), laquelle jouxte la zone délimitée à enlever, **caractérisé en ce que**
le matériau anti-adhésion (8, 21) est formé par un mélange d'un agent de séparation à base d'au moins un savon métallique, d'un liant et d'un solvant, et
l'agent de séparation est employé en une quantité inférieure à 60 % en poids du matériau anti-adhésion.

2. Procédé selon la revendication 1, **caractérisé en ce que** l'agent de séparation à base d'acides gras saturés et insaturés est employé.

3. Procédé selon la revendication 1 ou 2, **caractérisé en ce qu'**un dérivé cellulosique est employé en tant que liant.

4. Procédé selon l'une des revendications 1 à 3, **caractérisé en ce que** la quantité de liant est choisie inférieure à 35 % en poids.

5. Procédé selon l'une des revendications 1 à 4, **caractérisé en ce que** le solvant présente un point d'ébullition inférieur à 220 °C.

6. Procédé selon l'une des revendications 1 à 5, **caractérisé en ce qu'**un éther et un ester d'éthylène ou de polypropylène glycol sont employés en tant que solvant.

7. Procédé selon l'une des revendications 1 à 6, **caractérisé en ce que** la quantité de solvant est inférieure à 85 % en poids du matériau anti-adhésion (8, 21) .

8. Procédé selon l'une des revendications 1 à 7, **caractérisé en ce que** le matériau anti-adhésion (8, 21) est appliqué par un procédé par pression.

9. Procédé selon l'une des revendications 1 à 8, **caractérisé en ce que** le matériau anti-adhésion (8, 21) après application est soumis à un procédé de séchage et/ou de durcissement.

10. Procédé selon l'une des revendications 1 à 9, **caractérisé en ce que** le matériau anti-adhésion (8, 21) est étalé avec une épaisseur de couche inférieure à 25 µm.

11. Procédé selon l'une des revendications 1 à 10, **caractérisé en ce que** le matériau anti-adhésion (8, 21) présente une différence de polarité par rapport aux couches ou aux épaisseurs sensiblement planes se rattachant à celui-ci.

12. Procédé selon l'une des revendications 1 à 11, **caractérisé en ce que** le matériau anti-adhésion (8, 21) présente un point de ramollissement ou de fusion d'au moins 120 °C.

13. Procédé selon l'une des revendications 1 à 12, **caractérisé en ce qu'**après enlèvement de la zone délimitée (11, 25) à enlever, le matériau anti-adhésion (8, 21) est enlevé par application d'un milieu de stripage (28).

14. Procédé selon la revendication 13, **caractérisé en ce que** le solvant est choisi dans le groupe contenant de l'éthylène glycol, un éther de diéthylène glycol et de polyglycol, de l'hexylglycol, du butyldiglycol, un éther et un ester de propylène glycol, ainsi que des solvants chlorés.

15. Procédé selon l'une des revendications 13 à 14, **caractérisé en ce que** l'acide dans le milieu de stripage (28) est employé en une quantité inférieure à 20 % en poids.

16. Procédé selon l'une des revendications 13 à 15, **caractérisé en ce que** l'acide dans le milieu de stripage (28) est formé par des acides anorganiques ou des acides organiques ou des acides complexants.

17. Procédé selon l'une des revendications 13 à 16, **caractérisé en ce que** l'enlèvement du matériau anti-adhésion (8, 21) est exécuté en employant le milieu de stripage (28) à une température inférieure à 150 °C.

18. Procédé selon l'une des revendications 1 à 17, **caractérisé en ce que** les couches (2, 4, 9 ; 20, 22, 23) ou les épaisseurs à relier entre elles de la carte à circuits imprimés (1) multicouche sont reliées par un processus de laminage.

19. Procédé selon l'une des revendications 1 à 18, **caractérisé en ce que** des zones de bord (7, 24) de l'au moins une zone délimitée (11, 25) à enlever sont définies et/ou enlevées par fraisage, gravure, découpe.

20. Matériau anti-adhésion pour une utilisation dans un procédé selon l'une des revendications 1 à 19, **caractérisé en ce qu'**un matériau anti-adhésion (8, 21) est formé par un mélange composé d'un agent de séparation à base d'au moins un savon métallique, d'un liant et d'un solvant et que l'agent de séparation est employé en une quantité inférieure à 60 % en poids du matériau anti-adhésion.

21. Utilisation d'un procédé selon l'une des revendications 1 à 19 ou d'un matériau anti-adhésion selon la revendication 20 pour la fabrication d'une carte à circuits imprimés (1) multicouche.

22. Utilisation selon la revendication 21, pour la génération d'espaces creux ou cavités (25) dans une carte à circuits imprimés.

23. Utilisation selon la revendication 21, pour la génération d'au moins un canal dans une carte à circuits imprimés.

24. Utilisation selon la revendication 22 ou 23, pour l'incorporation de composants électroniques et/ou mécaniques.

25. Utilisation selon la revendication 22 ou 23, pour la conduction de sons, de lumière, de liquide et/ou de gaz.

26. Utilisation selon la revendication 22 ou 23, pour le logement de composants et d'éléments électroniques dans les espaces creux ou cavités (26).

27. Utilisation selon la revendication 22 ou 23, **caractérisée en ce que** les espaces creux, cavités ou canaux (26) sont remplis, recouverts ou revêtus de couches conductrices, isolantes, inhibitrices, résorbantes, réfléchissantes ou d'étanchéité successivement par des procédés de séparation chimiques, physiques ou galvaniques.

28. Utilisation selon la revendication 21, pour la libération d'au moins un élément à l'intérieur ou dans des épaisseurs internes d'une carte à circuits imprimés (1) multicouche.

29. Utilisation selon la revendication 21, pour la fabrication de zones délimitées (26) décalées et/ou réalisées sous une forme échelonnée d'une carte à circuits imprimés (1).

30. Utilisation selon la revendication 21, pour la fabrication d'une carte à circuits imprimés (1) flexo-rigide.
